# EUROPEAN PATENT APPLICATION

(11) **EP 4 498 777 A1**
(43) Date of publication of application: **29.01.2025**
(21) Application number: 23196443.8
(22) Date of filing: 11.09.2023
(51) Int. Cl.: H10K 30/40, H10K 30/57

(54) **OPTOELECTRONIC COMPONENT COMPRISING A PEROVSKITE PHOTOACTIVE LAYER AND AN ORGANIC PHOTOACTIVE LAYER**

(30) Priority: 27.07.2023 DE 102023120027
(71) Applicant: Heliatek GmbH, 01139 Dresden (DE)
(72) Inventor: Weiss, Andre, 01139 Dresden (DE); Uhrich, Christian, 01139 Dresden (DE); Le, Phuong, 01139 Dresden (DE)

(57) **Abstract**

The invention relates to an optoelectronic component (100), comprising a first electrode (2), a second electrode (9), and a stack (20) arranged between the first electrode (2) and the second electrode (9), the stack (20) comprising at least a first photoactive layer (4) and a second photoactive layer (7), wherein the first photoactive layer (4) comprises at least one perovskite absorber material having a wide band-gap, and the second photoactive layer (7) is an organic photoactive layer having a narrow band-gap comprising at least one donor and at least one acceptor as organic absorber materials forming a donor/acceptor heterojunction, wherein the at least one donor of the second photoactive layer is a A-D-A compound and/or a BODIPY compound.

## Description

The present invention relates to an optoelectronic component comprising a first electrode, a second electrode, and a stack arranged between the first electrode and the second electrode, the stack comprising at least a first photoactive layer and a second photoactive layer, wherein the first photoactive layer comprises at least one perovskite absorber material having a wide band-gap, and the second photoactive layer is an organic photoactive layer having a narrow band-gap comprising at least one donor and at least one acceptor as organic absorber materials forming a donor/acceptor heterojunction.

Solar cells generate energy by converting light into electricity based on the photovoltaic effect. Different types of solar cells have been developed including CIGS, organic, silicon, and perovskite solar cells.

Organic solar cells comprise a sequence of thin layers comprising organic compounds, polymers or small molecules, preferably applied by vacuum deposition or from solution. Electrical contacts can be formed by metal layers, transparent conductive oxides (TCOs) and/or transparent conductive polymers (PEDOT-PSS, PANI). A structure of a common organic solar cell which is already known from the literature consists of pin or nip diodes [Martin Pfeiffer, "Controlled doping of organic vacuum deposited dye layers: basics and applications," PhD thesis, TU-Dresden, 1999, and WO 2011/161108 A1]: A nip solar cell consists of a substrate with subsequent transparent base contact, n-layer(s), i-layer(s), p-layer(s), and a top contact, wherein n- or p-doping leads to an increase in the density of free electrons or holes in the thermal equilibrium state. Such layers are to be understood primarily as transport layers. It is also possible for n- or p-layer(s) to be at least partially nominally undoped and to preferably have n-conducting or p-conducting properties merely on the basis of the material properties (e.g. different charge carrier mobility) or on the basis of different impurities (e.g. remaining residues from the synthesis or the layer production), or due to influences of the environment (e.g. adjacent layers, inward diffusion of metals or other organic materials, gas doping from the ambient atmosphere). The term i-layer denotes an undoped or intrinsic layer, which is in particular a photoactive layer. One or more i-layers can consist of one material (planar heterojunctions) or of a mixture of two or more materials (bulk heterojunctions), which have an interpenetrating network.

Organic solar cells based on BODIPY and/or A-D-A absorber materials are known to provide decent photovoltaic performance with respect to power conversion efficiency (PCE) and durability. It has been proven that these materials can be processed on production scale, delivering commercially highly relevant organic solar films with decent efficiency and reliability. Typically, BODIPY and A-D-A absorber materials have high absorption strength in a confined absorption range, i.e. the power conversion efficiency is especially high around the respective absorption maximum, but due to relatively narrow absorption ranges only a part of the solar spectrum is covered which is limiting the overall PCE. In contrast to inorganic semiconductors, a band gap above whose energy all photons are absorbed does not exist.

The theoretical efficiency limit of a tandem- or multijunction solar cell is higher than for a single junction solar cell (Shockley-Queisser-Limit), correspondingly, devices combining organic photovoltaic subcells with organic or inorganic subcells in a tandem- or multijunction device were reported. In organic solar cells the subcell absorbing in the blue-green region is often limiting the overall photocurrent and efficiency (PCE). Combining wide band-gap and narrow band-gap photoactive layers in a tandem device is an effective approach to absorb radiation in a broad range of wavelengths. In particular the tuneability of organic absorber materials in the organic subcell with different band-gaps and various physical parameters is expected to construct a suitable combination of a organic subcell with a perovskite subcell. Thus, perovskite/organic tandem cells have attracted attention due to their theoretical light-harvesting range and efficiency potential. Typically, a tandem device comprises a wide band-gap perovskite subcell and a narrow band-gap organic subcell with an interconnecting layer (ICL) between the subcells. The performance is mainly restricted by the organic subcell and the ICL, which plays a critical role in the device performance. The ICL which connects the subcells serves as the carrier recombination zone and plays an important role in balancing the photovoltaic parameters of the device. The energy level alignment between the subcells and the ICL requires a careful design.

Xie et al. (Nano Select 2021;1-11) discloses monolithic perovskite/organic tandem solar cells and discusses the efficiency loss of perovskite/organic tandem devices compared to single-junction perovskite cells.

Chen et al. (Efficient and Reproducible Monolithic Perovskite/Organic Tandem Solar Cells with Low-Loss Interconnecting Layers, Joule, 2020, Volume 4, Issue 7, P1594-1606) discloses efficient and reproducible monolithic perovskite/organic tandem solar cells with low-loss interconnecting layers.

Tandem- or multijunction devices, however, suffer from drawbacks. Typically, the durability these devices is sensitive. Tandem- or multijunction devices are more prone to degradation because degradation of any of the subcells affects the performance of the whole device. Furthermore, a charge recombination zone between the subcells can represent another weak spot that limits durability. Furthermore, combination of two or more subcells in a tandem- or multijunction device leads to a higher complexity in manufacturing of the respective device, due the higher number of layers, and in many cases due to the necessity to combine different manufacturing or deposition technologies to provide the final devices (e.g., wet coating and vacuum deposition).

The object of the present invention is, in particular, to increase the power conversion efficiency (PCE) of organic solar cells based on organic absorber molecules, in particular without negatively affecting their intrinsic durability.

The object is achieved by means of the subject-matter of the independent claims. Advantageous embodiments are evident from the dependent claims.

The object of the present invention is in particular solved by an optoelectronic component, preferably a photovoltaic element with at least one photovoltaic cell, comprising a first electrode, a second electrode, and a stack arranged between the first electrode and the second electrode, the stack comprising at least a first photoactive layer and a second photoactive layer, wherein the first photoactive layer comprises at least one perovskite absorber material having a wide band-gap, and the second photoactive layer is an organic photoactive layer having a narrow band-gap comprising at least one donor and at least one acceptor as organic absorber materials forming a donor/acceptor heterojunction, wherein the at least one donor of the second photoactive layer is a A-D-A compound and/or a BODIPY compound. According to the present invention the wide band-gap of the first photoactive layer is larger compared to the narrow band-gap of the second photoactive layer. Thus, an organic subcell is combined with a perovskite subcell to form a tandem cell or a multijunction cell benefiting from their complementary band-gaps. A tandem cell is, in particular, an electronic component consisting of a vertical layer system of two cells connected in series. Correspondingly, a multijunction cell is, in particular, an electronic component consisting of a vertical layer system of several cells connected in series.

In the context of the present invention a photoactive layer is a layer which actively contributes as an absorber layer by absorption of light and conversion into electrical energy. In this context the term photoactive is understood to mean the conversion of light energy to electrical energy, e.g. the optoelectronic component converts light energy into electrical energy, the photoactive layers being, in particular, light-absorbing layers.

In the context of the present invention an organic photoactive layer, in particular, comprises organic conductive or semiconductive compounds, wherein in the photoactive layer excitons (electron-hole pairs) can be formed by means of irradiation.

In the context of the present invention the wide band-gap of the first photoactive layer is related to the narrow band-gap of the second photoactive layer, which first photoactive layer has a larger band-gap compared to the second photoactive layer.

In a preferred embodiment the first electrode is a front electrode, preferably a transparent electrode, und the second electrode is a back electrode, in particular the front electrode is arranged at a light-facing side of the optoelectronic component as intended. In a preferred embodiment the first photoactive layer comprising the at least one perovskite absorber material is facing the front electrode. In an alternative embodiment, the first photoactive layer comprising the at least one perovskite absorber material is facing the back electrode.

In a preferred embodiment the first photoactive layer has a layer thickness of 50 nm to 500 nm, preferably of 100 nm to 500, preferably of 50 nm to 400, preferably of 100 nm to 400, preferably of 50 nm to 300 nm, preferably of 100 nm to 300, or preferably of 100 nm to 200 nm. In a preferred embodiment the second photoactive layer has a layer thickness of 5 nm to 50 nm, preferably 10 nm to 50 nm, or preferably 10 nm to 30 nm. Advantageously, the thin layer thickness of the organic photoactive layer due to the very strong absorption of the absorber material in a limited wavelength range allows taking advantage of thin film optics. The photoactive layers can be perfectly placed in the intensity maxima resulting from the incident and reflected light. The comparatively thin photoactive layers are embedded in transport layers to optimally conduct charge carriers to the contacts and, thus, provide high efficiency and prevent degradation of the subcells, e.g. by segregation.

In the context of the present invention, a BODIPY compound refers to a compound derived from a core structure of general formula C₉H₇BN₂F₂, in particular a compound having a Bor-Difluorid-group having a Dipyrromethen-group, more particular a compound 4,4-Difluoro-4-bora-3a,4a-diaza-s-Indacene.

In a preferred embodiment the BODIPY compound is a compound of the general formula B1 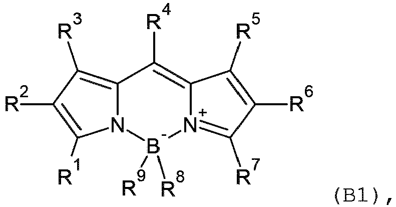
wherein R1 and R2 and/or R6 and R7, in each case together, form a heterocyclic 5-membered ring or 6-membered ring having at least one heteroatom selected from S, O, N and P, or a homocyclic 6-membered ring having no further fusion, and R1 and R2 or R6 and R7 are independently an H or another radical if they do not form a heterocyclic or homocyclic ring,
R3, R4 and R5 are independently H or a radical selected from aryl, alkyl, fluorinated or partly fluorinated alkyl, unsaturated alkyl, and R8 and R9 are F. In a preferred embodiment in the compound B1 R1 and R2 and/or R6 and R7, in each case together, form a heterocyclic 5-membered ring or 6-membered ring having at least one heteroatom selected from S, O, N and P.

In a preferred embodiment the BODIPY compound is a compound of general formula B2 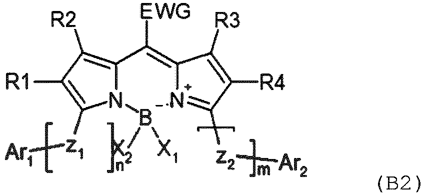
wherein n, m are each independently 0, 1 or 2;
wherein X1, X2 are each independently selected from halogen, CN, alkyl, fluorinated or partially fluorinated alkyl, alkenyl, alkynyl, alkoxy, aryl or heteroaryl;
wherein EWG is selected from CN, or CF3, or a fully or partially fluorinated, branched or unbranched, linear or cyclic alkyl chain in which H atoms and/or C atoms may be substituted;
wherein z1 and z2 selected from the groups (II) to (IV): 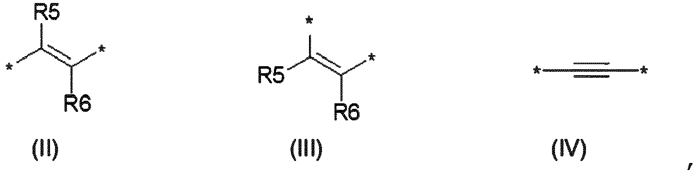
wherein "*" denotes in each case the bonding side the substituent z1 or z2 to the dipyrrin skeleton and to the aryl substituents Ar1, Ar2
wherein R1 to R4 are each independently selected from H, CN, halogen, substituted or unsubstituted, branched or unbranched, linear or cyclic alkyl chain;
wherein R5 and R6 are each independently selected from H, halogen, CN, substituted or unsubstituted, branched or unbranched, linear or cyclic alkyl chain;
in which Ar1 and Ar2 are each independently selected from aryl or heteroaryl, wherein Ar1 in the case of n = 0 and/or Ar 2 in the case of m = 0 corresponds to the formula (V), and "*" is the bonding side of the substituent Ar1, Ar2 refers to the dipyrrin skeleton, 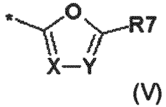
wherein X is selected from N or C-R8 and Y is selected from N or C-R9; wherein R7 to R9 are independently selected from a group consisting of H, halogen, branched or linear, cyclic or open-chain alkyl or aryl, wherein H atoms and/or C atoms of the alkyl or aryl may be substituted, or from a group of consisting alkenyl, O-alkyl, S-alkyl, O-alkenyl, S-alkenyl, alkynyl, aryl or heteroaryl, wherein in all these groups H atoms may be substituted, or from CN or NR'R ", with R 'and R" each independently selected from: H, branched or linear, cyclic or open-chain alkyl, wherein H and / or C atoms of the alkyl may be substituted; or wherein R7 and R9 may together form a homo- or heterocyclic, saturated or unsaturated, substituted or unsubstituted ring; and Ar1 is in the case of n> 0 and/or Ar 2 is in the case of m> 0, a substituted or unsubstituted heterocyclic 5-membered ring, with preferably heteroatoms selected from S or O.

In a preferred embodiment the BODIPY compound is a compound of general formula B3 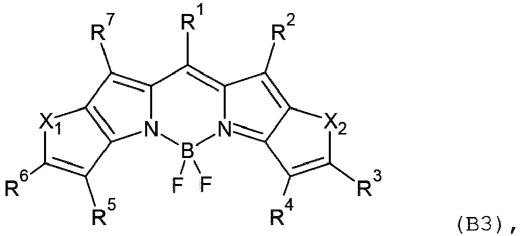
wherein X1 and X2 independently of one another are O, S or N-R8, with R8 selected from the group consisting of H, alkyl, aryl, and heteroaryl,
R1 is a substituted homocyclic 6-membered ring, wherein at least one H atom is substituted by an electron-withdrawing substituent selected from the group consisting of F, Cl, CN, CF3, and COR8, with R8 being C1-C4 alkyl, or is a substituted or unsubstituted heterocyclic 5-membered ring or 6-membered ring, wherein the heterocyclic 5-membered ring or 6-membered ring has at least one sp2-hybridized N atom with a free electron pair and/or has at least one heteroatom selected from O, S, or N, wherein in the substituted heterocyclic 5-membered ring or 6-membered ring at least one H atom is substituted by an electron-withdrawing substituent selected from the group consisting of F, Cl, CN, CF₃, and COR9, with R9 being C1-C4 alkyl,
R2 and R7 independently of one another are selected from the group consisting of H, halogen, CN, alkyl, fluorinated or partially fluorinated alkyl, unsaturated alkyl, and aryl,
R4 and R5 independently of one another are selected from the group consisting of H, halogen, CN, alkyl, fluorinated or partially fluorinated alkyl, unsaturated alkyl, and alkoxy, and
R3 and R6 independently of one another are a substituted or unsubstituted homocyclic 6-membered ring or a substituted or unsubstituted heterocyclic 5-membered ring or 6-membered ring.

In a preferred embodiment in the compound of general formula B3, X1 and X2 are S or X1 and X2 are O, and/or at least one H atom in the homocyclic 6-membered ring and/or in the heterocyclic 5-membered ring or 6-membered ring R1 is substituted by F or CF₃, preferably by F.

In a preferred embodiment in the compound of general formula B3, R3 and R4 and/or R5 and R6 in each case together form a heterocyclic 5-membered ring or 6-membered ring having at least one heteroatom selected from O, S or N, preferably O or S, wherein preferably the heterocyclic 5-membered ring or 6-membered ring is non-substituted, or form a homocyclic 6-membered ring.

In a preferred embodiment the BODIPY compound is a compound of general formula B4 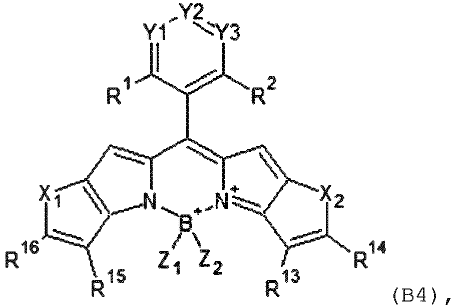
with Y₁ selected from the group consisting of N and CR21, wherein R21 is selected from the group consisting of H, alkyl, O-alkyl, S-alkyl, halogen, preferably F or Cl, CN and CF₃;
with Y₂ selected from the group consisting of N and CR22, wherein R22 is selected from the group consisting of H, alkyl, O-alkyl, S-alkyl, halogen, preferably F or Cl, CN, and CF₃;
with Y₃ selected from the group consisting of N and CR23, wherein R23 is selected from the group consisting of H, alkyl, O-alkyl, S-alkyl, Halogen, preferably F or Cl, CN, and CF₃;
with Z₁ and Z₂ F or CF₃;
with X₁ and X₂ independently from each other O, S or N-R8, wherein R8 is selected from the group consisting of H, alkyl and aryl, wherein preferably X₁ and X₂ are S, or X₁ and X₂ are O;
with R1 and R2 independently from each other selected from the group consisting of H, F, Cl, Br, CN, CF₃, CHF₂, CH₂F, C1-C4-alkyl, O-C1-C4-alkyl, S-C1-C4-alkyl, and N-(C1-C4-alkyl)₂, with the proviso that at least R1 or R2 is Br, Cl, CF₃, CHF₂, CH₂F or CH₃; wherein R13 and R15 are independently from each other selected form the group consisting of H, halogen, CN, alkyl, O-alkyl, and S-alkyl, preferably H or C1-C4-alkyl;
wherein R14 and R16 are independently selected from the group consisting of a non-substituted or with halogen, alkyl, at least partially fluorinated alkyl, O-alkyl and/or at least partially fluorinated O-alkyl substituted heterocyclic 5-membered ring or 6-membered ring, preferably with a heteroatom independently selected from S, O and N, und a non-substituted and with halogen, alkyl, at least partially fluorinated alkyl, O-alkyl and/or at least partially fluorinated O-alkyl substituted homocyclic 6-membered ring, preferably a non-substituted or substituted heterocyclic 5-membered ring, and a non-substituted or substituted homocyclic 6-membered ring.

In a preferred embodiment the BODIPY compound is a compound of general formula B5 and B6 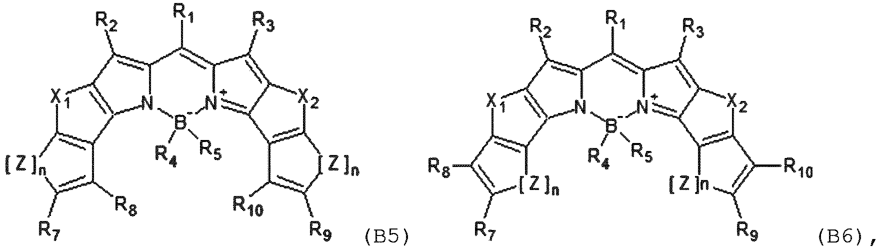
with X₁ and X₂ independently from each other O, S, or NR₆,
with R₆ selected from the group consisting of H, alkyl, alkoxy, amino, aryl, and heteroaryl,
with R₁ selected from the group consisting of F, at least partially fluorinated alkyl, and an aromatic heterocyclic 5-membered ring or 6-membered ring or aa aromatic homocyclic 6-membered ring,
with R₂ and R₃ independently from each other selected from the group consisting of H, halogen, CN, alkyl, alkoxy, amino, aryl and heteroaryl,
with R₄ and R₅ independently from each other selected from the group consisting of halogen, preferably F, and fluorinated or partially fluorinated alkyl,
with Z independently from each other selected from the group consisting of O, S, CH₂, CHR₁₁, CR₁₂R₁₃, SiHR₁₁, SiR₁₂R₁₃, NH, NR₁₄, PR₁₅, with Rn, R₁₂, R₁₃, R₁₄ and R₁₅ independently selected form the group consisting of halogen, alkyl, alkoxy, amino, aryl, and heteroaryl, with n independently 1 or 2,
wherein R₇ and R₈ and/or R₉ and R₁₀ together form a heterocyclic 5-membered ring or a 6-membered ring comprising at least one heteroatom selected from the group consisting of O, S, N, Si and P, or a homocyclic 6-membered ring, wherein the heterocyclic 5-membered ring or 6-membered ring or the homocyclic 6-membered ring each can be fused.

In the context of the present invention, an ADA compound or an ADA-oligomer refers to a conjugated acceptor-donor-acceptor-oligomer (ADA') having a first acceptor-unit (A) and a second acceptor-unit (A'), each bound to the donor-unit (D).

In a preferred embodiment the A-D-A compound is:
a conjugated Acceptor-Donor-Acceptor-Oligomer (A-D-A'-Oligomer) with a acceptor unit (A) and a further acceptor unit (A'), each bound to a donor unit (D), wherein the donor unit (D) is an extended donor unit, wherein the donor unit (D) comprises at least two monomers and/or at least 8 atoms having a common conjugated π-electron-system, which are formed from at least one atom selected from the group consisting of C, N, B, P, S, Si and O; or
a conjugated Acceptor-Donor-Acceptor-Oligomer (A-D-A'-Oligomer) with a acceptor unit (A) and a further acceptor unit (A'), each bound to a donor unit (D), wherein the acceptor unit (A) and a further acceptor unit (A') each are an extended acceptor unit, wherein the acceptor unit (A) and the further acceptor unit (A') each comprises at least two monomers and/or at least 8 atoms having a common conjugated π-electron-system, which are formed from at least one atom selected from the group consisting of C, N, B, P, S, Si and O; or
a conjugated Acceptor-Donor-Acceptor-Oligomer (A-D-A'-Oligomer) with a acceptor unit (A) and a further acceptor unit (A'), each bound to a donor unit (D), wherein either at least the donor unit (D) is an extended donor unit or at least the acceptor unit (A) and a further acceptor unit (A') each are an extended acceptor unit, wherein in case of an extended structure the donor unit (D), the acceptor unit (A) and the further acceptor unit (A') comprises at least two monomers and/or at least 8 atoms having a common conjugated π-electron-system, which are formed from at least one atom selected from the group consisting of C, N, B, P, S, Si and O.

In a preferred embodiment die A-D-A compound is a compound of general formula A1: 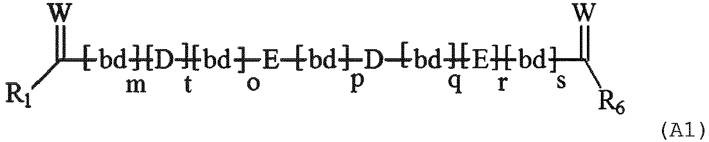
wherein each W is independently selected from C(CN)₂, CHCN, C(CN)COOR' wherein R' is in each case selected from C1-C10 alkyl, C3-C10 aryl and C2-C8 heteroaryl, more preferably selected from C(CN)₂, CHCN,
R₁ and R₆ are each independently selected from H, C1-C30 alkyl, C1-C30 perfluoroalkyl, C3-C10 aryl, C2-C8-heteroaryl, CN, wherein the D groups are selected from: 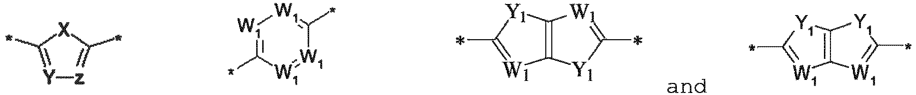
wherein Y₁ is selected from: O, S, Se, P(R), P(O)R, Si(RR'), C(RR') and N(R) and
W₁ is independently selected from: N and C-R wherein R and R' are each independently selected from substituted and unsubstituted C1 to C30 alkyl, C3-C6 aryl and C3-C8 heteroaryl and wherein each X is selected independently from O, NR', S, Se, wherein R' is selected from C1-C30 alkyl, C1-C10 aryl and C1-C8 heteroaryl,
each Y is independently selected from N and CR9 wherein R9 = H, halogen, C1-C30 alkyl, C1-C30 alkenyl, C1-C30 alkynyl, each linear or branched, substituted or unsubstituted, OR', SR', SiR'₃, NR'₂, wherein R' is selected from C1-C10 alkyl, C3-C10 aryl and C1-C8 heteroaryl,
each Z is independently selected from N and CR10 wherein R10 = H, halogen, C1-C30 alkyl, C1-C30 alkenyl, C1-C30 alkynyl, each linear or branched, substituted or unsubstituted, OR', SR', SiR'₃, NR'₂, wherein R' is selected from C1-C10 alkyl, C3-C10 aryl and C1-C8 heteroaryl,
wherein R9 and R10 may form a ring, preferably a 5-membered or 6-membered ring,
wherein the E groups are selected from: 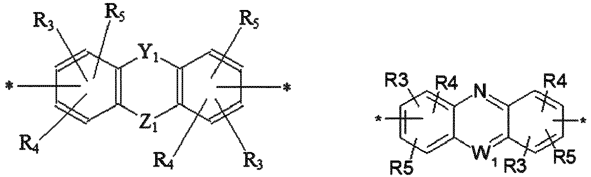 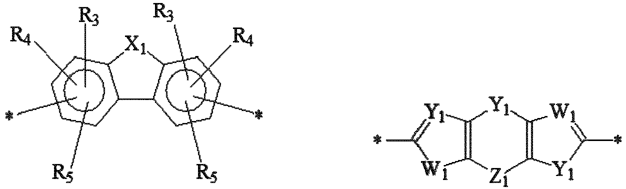 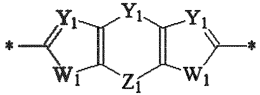 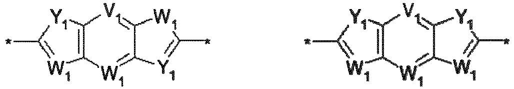 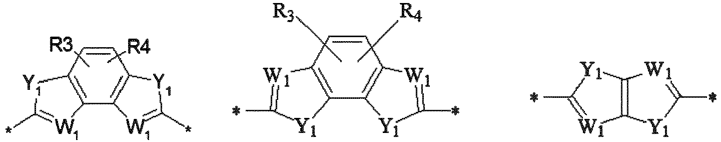 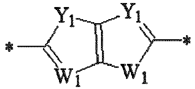 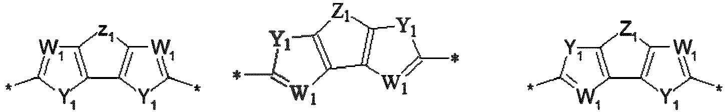 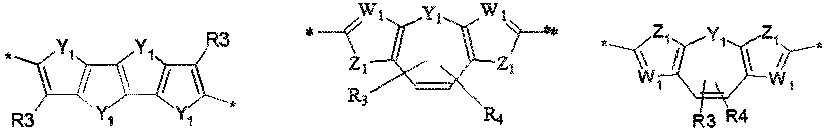
wherein V₁ and W₁ are each independently selected from: N and C-R wherein R = H, halogen, C1-C30 alkyl, C1-C30 alkenyl, C1-C30 alkynyl, each linear or branched, substituted or unsubstituted, C3-C10 aryl or C1-C8 heteroaryl, substituted or unsubstituted, OR', SR', SiR'₃, NR'₂, wherein R' is selected from C1-C10 alkyl, C1-C10 aryl and C1-C8 heteroaryl,
Y₁ and Z₁ are each selected from: O, S, Se, P (R), P(O)R, Si(RR'), C(RR') and N(R), wherein R and R' are each independently selected from H, linear or branched, substituted or unsubstituted C1-C30 alkyl, substituted or unsubstituted aryl, substituted or unsubstituted heteroaryl, acyl (COR'), COOR' and OR', wherein R' is selected from C1-C30 alkyl, C3-C10 aryl and C1-C8 heteroaryl, and
X₁ is selected from: O, S, Se, and R and R' are each independently selected from H, C1 to C20 alkyl, linear or branched, substituted or unsubstituted, C3 to C6 aryl or C3 to C8 heteroaryl, OR', SR', SiR'₃, NR'₂, wherein R' is selected from C1-C10 alkyl, C3-C6 aryl and C3-C8 heteroaryl,
and wherein R3, R4 and R5 are each independently H, C1 to C20 alkyl, linear or branched, non-substituted or substituted, C3 to C6 aryl or C3 to C8 heteroaryl, OR', SR', SiR'₃, NR'₂, wherein R' may be selected from C1-C10 alkyl, C3-C6 aryl and C3-C8 heteroaryl,
bd is independently *-C≡C-* or *-C ≡ C-*,
n, m, o, p, q, and r, s and t may each independently be 0 or 1, with the proviso that at least one parameter is 1,
wherein one donor unit formed from the groups bd, E and D has at least 10 conjugated electrons and the bonds identified with the asterisk* indicate the bonds to further groups in the compounds.

In a preferred embodiment die A-D-A compound is a compound of general formula A2: 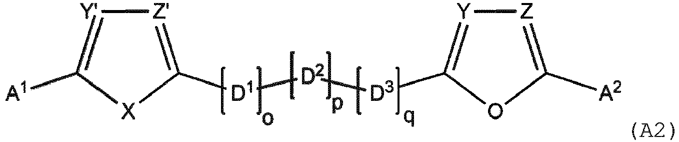
with Y, Y', Z and Z' each independently selected from: N or CR^{a}, with X selected from: O, S, Se, Si (R^{b}R^{c}), P(R^{b}), P(O)R^{b}, wherein the R^{a} to R^{c} radicals are each independently selected from the group of the following radicals: H, halogen, CN, NR^{d}R^{e} wherein R^{d} and R^{e} are each independently selected from the group of the radicals: H, and cyclic or open-chain C₁-C₂₀-alkyl, wherein individual carbon atoms may be replaced by heteroatoms and wherein hydrogen atoms in the alkyl radical may be substituted, cyclic or open-chain C₁-C₂₀ alkyl, wherein individual carbon atoms may be replaced by heteroatoms, cyclic or open-chain C₁-C₂₀ O-alkyl, cyclic or open-chain C₁-C₂₀ S-alkyl, cyclic or open-chain C₂-C₂₀ alkenyl, cyclic or open-chain C₂-C₂₀ O-alkenyl, cyclic or open-chain C₂-C₂₀ S-alkenyl, cyclic or open-chain C₂-C₂₀ alkynyl, aryl, heteroaryl, wherein hydrogen atoms in the alkyl, O-alkyl, S-alkyl, alkenyl, O-alkenyl, S-alkenyl, alkynyl, aryl and heteroaryl radicals may each independently be substituted; and wherein A¹ is selected from the group of the following radicals: 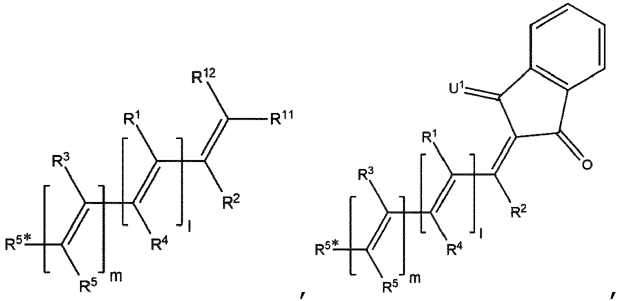 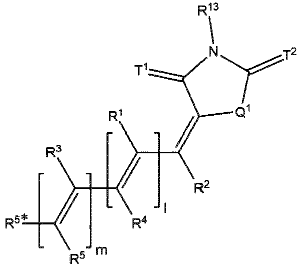
and wherein A² is selected from the group of the following radicals: 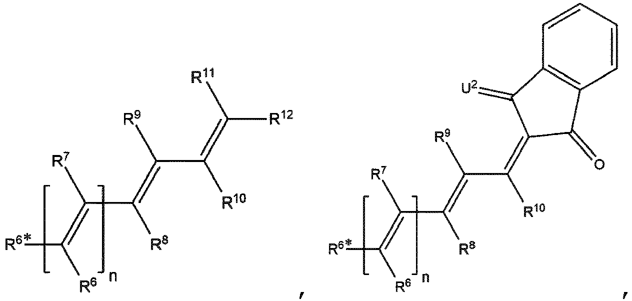 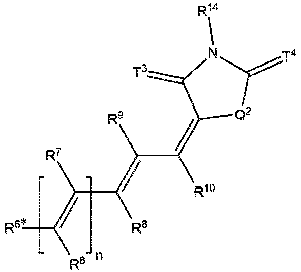
wherein m, 1 and n are each independently 0 or 1,
wherein R1 to R10 and R5* and R6* for the A1 and A2 groups are each independently selected from the group of the following radicals: H, halogen, CN, cyclic or open-chain C1-C20 alkyl, cyclic or open-chain C2-C20 alkenyl, cyclic or open-chain C1-C20 O-alkyl, aryl, heteroaryl, wherein hydrogen atoms in the alkyl, alkenyl, O-alkyl, aryl and heteroaryl radicals may each independently be substituted; and wherein it is possible in each case independently for a ring to be formed by the following pairs of radicals together: R1 and R3, R2 and R4, R4 and R5, R3 and R5*, R7 and R9, R6 and R8, R8 and R10, R6* and R7; with the proviso that, for A1, exactly one of the R5*, R5, R4, R3, R2 and R1 radicals represents a linkage 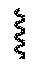 by means of which A1 is bonded to the structural element 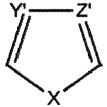 in the compound of the general formula (A2), and with the proviso that, for A², exactly one of the R^{6*}, R⁶, R⁷, R⁸, R⁹ and R¹⁰ radicals represents a linkage 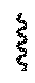 by means of which A² is bonded to the structural element 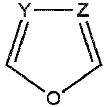 of the compound of the general formula (A2);
wherein R¹¹ and R¹² for the A¹ and A² groups are each independently selected from the group of the radicals: H, CN, COOR^{f} wherein R^{f} is selected from the group of the radicals: H and cyclic or open-chain C₁-C₂₀-alkyl, wherein hydrogen atoms in the alkyl may be fluorinated, with the proviso that R¹¹ and R¹² cannot both be H, wherein the R¹³ and R¹⁴ radicals are independently selected from the same group of radicals as R^{d} and R^{e}; and wherein U¹, U², and T¹ to T⁴ are each independently selected from the group consisting of: O, S and C(CN)₂; and wherein Q¹ and Q² are each independently selected from the group consisting of: O and S;
and wherein the conjugated D¹, D² and D³ blocks are each independently selected from the group of the following structural units: 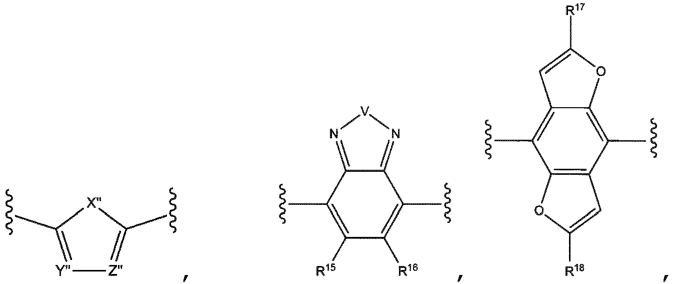 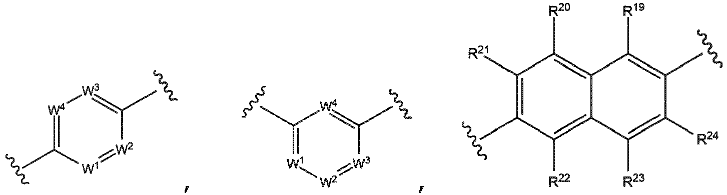 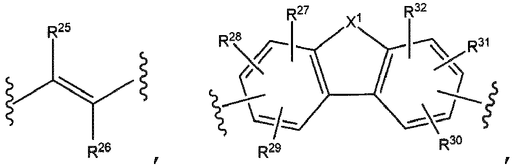 wherein the coefficients o and q each independently assume the values of 0 and 1 and the coefficient p assumes the values of 0, 1, 2, 3, 4 and 5, with the proviso that at least one of the coefficients o, p and q is not 0,
with Y" selected from: N or CR^{g};
with Z" selected from: N or CR^{h};
with X" selected from: O, S, Se, Si(RⁱR^{j}), P(Rⁱ), P(O)Rⁱ;
with V selected from: O, S or NR^{k};
with X¹ selected from: NR^{l}, CR^{l}R^{m};
with W¹ to W⁴ independently selected from: N, CRⁿ;
wherein the R^{g} to Rⁿ radicals and the R¹⁵ to R³² radicals are each independently selected from the group of the radicals as R^{a} to R^{c}; and wherein the R^{g} and R^{h} radicals may be joined to one another in the form of a ring structure and wherein an aryl radical may be fused onto the ring structure, wherein any aryl radical fused to the ring structure may be substituted.

In a preferred embodiment die A-D-A compound is a compound of general formula A3:

EWG1 -(T1)ₐ-(T2)_{b}-(Z)_{c}-(T3)_{d}-(T4)ₑ-EWG2 (A3)

with the parameters a, b, d and e being each independently of one another 0 or 1,
with the parameter c being 1, 2, 3, 4 or 5,
wherein the general group Z is a block of two groups M and N, linked as *-M-N-* or *-N-M-*, wherein * designates the attachment to the groups T1 to T4 or EWG1 and EWG2,
wherein the groups M each independently of one another are selected from: 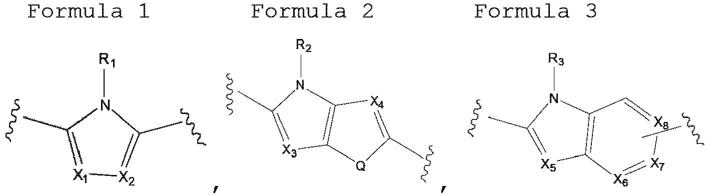
wherein the groups N each independently of one another are selected from: 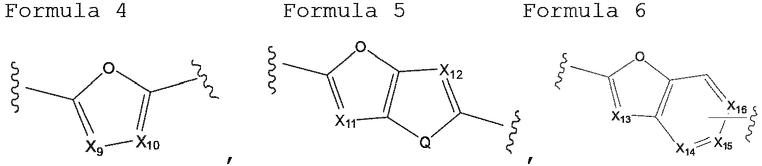
wherein M and N are each linked such that at least one N atom of the group M and one O atom of the group N are each joined to one another via 2 C atoms, and 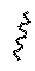 designates the attachment to the other groups in the compound of the general formula (A3),
with X₁-X₁₆ independently of one another being selected from N or C-R, with the proviso that in the groups of the formulae 3 and 6, in each case one group from the groups X₈/X₇ and X₁₆/X₁₅ designates the attachment 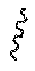 to the other groups in the compound of the general formula (A3),
with each R independently of any other being selected from a group composed of H, halogen, branched or linear, cyclic or open-chain C₁-C₂₀ alkyl, wherein hydrogen atoms of the C₁-C₂₀ alkyl may be substituted and C atoms of the C₁-C₂₀ alkyl may be replaced by heteroatoms; C₂-C₂₀ alkenyl, O-alkyl, S-alkyl, O-alkenyl, S-alkenyl, alkynyl, aryl, heteroaryl, it being possible for hydrogen atoms to be substituted in all of these groups; CN, NR'R'', with R' and R" each independently of one another being selected from: H, branched or linear, cyclic or open-chain C₁-C₂₀ alkyl, wherein hydrogen atoms of the C₁-C₂₀ alkyl may be substituted and C atoms of the C₁-C₂₀ alkyl may be replaced by heteroatoms, wherein R₁ to R₃ each independently of one another are selected from a group composed of H, branched or linear, cyclic or open-chain C₁-C₂₀ alkyl, wherein hydrogen atoms of the C₁-C₂₀ alkyl may be substituted and C atoms of the C₁-C₂₀ alkyl may be replaced by heteroatoms; substituted or unsubstituted C₂-C₂₀ alkenyl, substituted or unsubstituted aryl, substituted or unsubstituted heteroaryl, CN,
with each Q independently of any other being selected from S, O, Se, NR' ' ', wherein R‴ is defined as for R₁ to R₃,
wherein the electron-withdrawing groups EWG1 and EWG2 independently of one another are electron-withdrawing groups having at least one C=C double bond,
wherein the groups T1, T2, T3 and T4 each independently of one another are selected from: 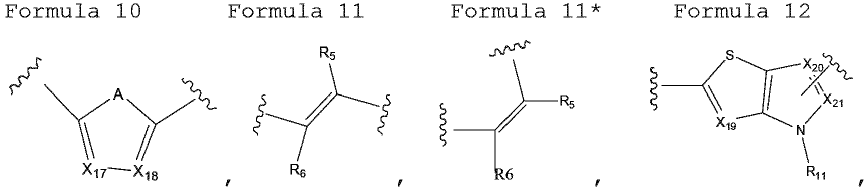 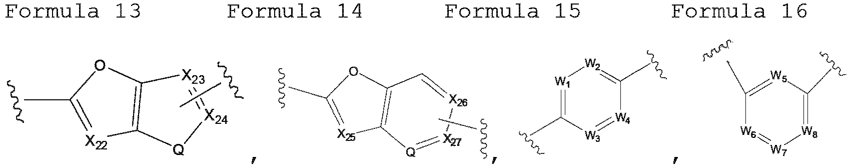 and 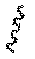 designates the attachment to the other groups in the compound of the general formula (A3),
with R5 and R6 each independently of one another being selected from a group: H, CN, F, aryl, heteroaryl, C₂-C₂₀ alkenyl, alkynyl, branched or linear, cyclic or open-chain C₁-C₂₀ alkyl, wherein hydrogen atoms of the C₁-C₂₀ alkyl may be substituted, where, if the substituent R₁₃ is present in the compound of the formula (A3), a ring closure between R₅ with R₁₃ or R₆ with R₁₃ is possible, with the proviso that between R₅ and R₁₃ or between R₆ and R₁₃ in each case the double bond from formula 11 is located, is possible, with W₁ to W₈ each independently of one another being selected from N, CR, wherein R is defined as described above,
with X₁₇ to X₂₇ independently of one another being selected from C-R, wherein R is defined as described above, and with the proviso that in the groups of the formulae 12, 13 and 14, in each case one group from the groups X₂₀/X₂₁, X₂₃/X₂₄ and X₂₆/X₂₇ designates the attachment 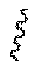 to the other groups in the compound of the general formula (A3),
with A being S, O, NR'' '" , Se
with Q being S, O, NRʺʺ, Se
wherein for the groups A and Q, the substituent Rʺʺ in each case independently of any other is selected from H, CN, branched or linear, cyclic or open-chain C₁-C₂₀ alkyl, wherein the H atoms of the C₁-C₂₀ alkyl may be substituted; C₂-C₂₀ alkenyl, O-alkyl, S-alkyl, O-alkenyl, S-alkenyl, alkynyl, substituted or unsubstituted aryl, substituted or unsubstituted heteroaryl.

In a preferred embodiment die A-D-A compound is a compound of general formula A4

A1-(T1)ₐ-(T2)_{b}-(Z)_{c}-(T3)_{d}-(T4)ₑ-A2 (A4)

with the parameters a, b, d, e each independently 0 or 1, with the proviso that at least one of the parameters a, b, d, e = 1,
with the parameter c = 1, 2, or 3,
wherein the general group Z is a block of two groups M and N, linked as *-M-N-*or *-N-M-*, wherein * denotes the attachment to the groups T1, T2, T3, T4, A1, and A2,
wherein the groups M are each independently selected from: 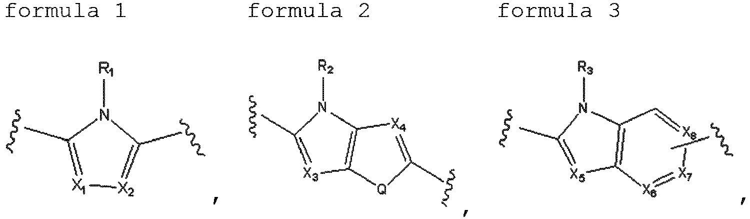 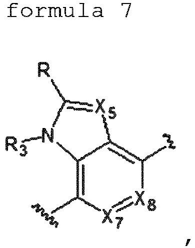
wherein the groups N are each independently selected from: 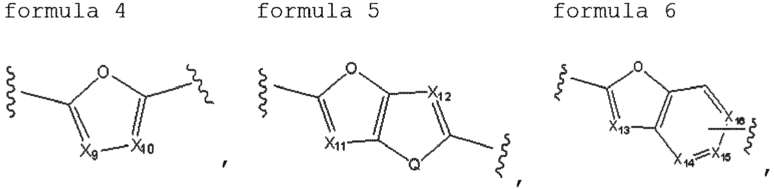 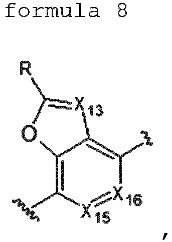
wherein M and N are each linked such that at least one N atom of the group M and an O atom of the group N are each bonded to one another via 2 C atoms, and 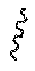 denotes the attachment to the other groups in the compound of the general formula (A4),
with X₁-X₁₆ independently selected from N or C-R, with the proviso that, in each of the groups of the formulas 3 and 6, a group from the groups X₈/X₇ and X₁₆/X₁₅ denotes the attachment / to the other groups in the compound of the general formula (A4),
with R in each case independently selected from the group consisting of H, halogen, branched or linear, cyclic or open-chain C₁-C₁₀ alkyl, wherein H atoms of the C₁-C₁₀ alkyl can be substituted, and C atoms of the C₁-C₁₀ alkyl can be substituted by heteroatoms, C₂-C₁₀ alkenyl, O-alkyl, S-alkyl, O-alkenyl, S-alkenyl, alkynyl, aryl, heteroaryl, wherein, in all of these groups, H atoms can be substituted, CN, NR₁₀R₁₁, with R₁₀ and R₁₁
each independently selected from H, branched or linear, cyclic or open-chain C₁-C₁₀ alkyl, wherein H atoms of the C₁-C₁₀ alkyl can be substituted, and C atoms of the C₁-C₁₀ alkyl can be substituted by heteroatoms,
with R₁ to R₃ each independently selected from the group consisting of H, branched or linear, cyclic or open-chain C₁-C₁₀ alkyl, wherein H atoms of the C₁-C₁₀ alkyl can be substituted, and C atoms of the C₁-C₁₀ alkyl can be substituted by heteroatoms, substituted or unsubstituted C₂-C₁₀ alkenyl, substituted or unsubstituted aryl, substituted or unsubstituted heteroaryl, CN,
wherein the electron-withdrawing groups A1 and A2 are, independently, electron-withdrawing groups having at least one C=C double bond,
wherein the groups T1, T2, T3, and T4 are each independently selected from: 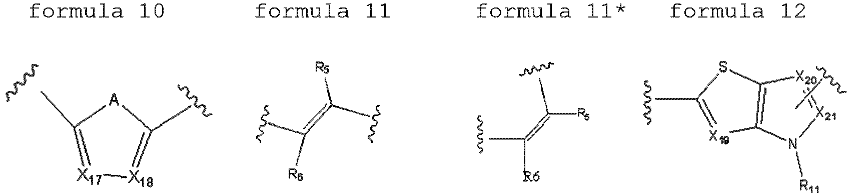 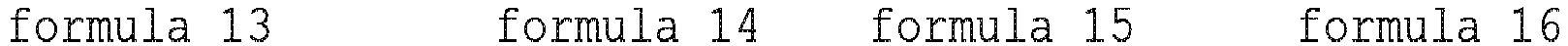 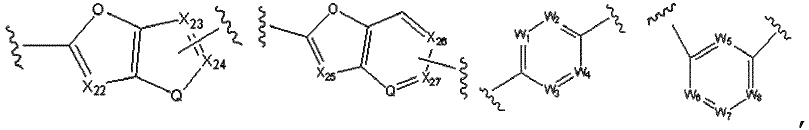
wherein / denotes the attachment to the other groups in the compound of the general formula (A4), with the proviso that at least one of the groups T1 to T4 is the formula 10,
with R₅ and R₆ each independently selected from the group consisting of H, CN, F, aryl, heteroaryl, C₂-C₁₀ alkenyl, alkynyl, branched or linear, cyclic or open-chain C₁-C₁₀ alkyl, wherein H atoms of the C₁-C₁₀ alkyl can be substituted, wherein, if the substituent R₁₃ is present in the compound of the formula (A4), a ring closure between R₅ with R₁₃ or R₆ with R₁₃ is possible, with the proviso that, between R₅ and R₁₃ or between R₆ and R₁₃, in each case there is located the double bond from formula 11,
with W₁ to W₈ each independently selected from N, CR, wherein R is defined as described above,
with X₁₇ and X₁₈ independently selected from N and C-R, wherein R is defined as described above, with the proviso that X₁₇ or X₁₈ is N, with X₁₉ to X₂₇ independently selected from N and C-R, wherein R is defined as described above, and with the proviso that, in each of the groups of the formulas 12, 13, and 14, a group from the groups X₂₀/X₂₁, X₂₃/X₂₄, and X₂₆/X₂₇ denotes the attachment 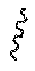 to the other groups in the compound of the general formula (A4),
with A selected from the group consisting of S, O, NR₉, and Se, with Q selected from the group consisting of S, O, NR₉, and Se, wherein, for the groups A and Q, the substituent R₉ is in each case independently selected from H, CN, branched or linear, cyclic or open-chain C₁-C₁₀ alkyl, wherein the H atoms of the C₁-C₁₀ alkyl may be substituted, C₂-C₁₀ alkenyl, O-alkyl, S-alkyl, O-alkenyl, S-alkenyl, alkynyl, substituted or unsubstituted aryl, substituted or unsubstituted heteroaryl.

The optoelectronic component according to the present invention has advantages in comparison to the prior art. Advantageously, the efficiency of the optoelectronic component, in particular a photovoltaic element, can be increased. Advantageously the combination of A-D-A- and/or BODIPY-absorber material in tandem or multijunction devices with perovskite wide band-gap absorber materials allow higher efficiency. Advantageously, a high V_{oc} of more than 2.0 V is achievable. Advantageously in such an optoelectronic component light in a broad spectral range, in particular, in the blue-green range and the red/near infrared range, is absorbed. Advantageously, the efficiency of a tandem cell comprising two organic subcells can be increased by substituting one of the organic subcells by a perovskite subcell. Surprisingly, the durability of the optoelectronic component can be increased. The lifetime of the optoelectronic component is increased. Advantageously organic photoactive layers as well as perovskite photoactive layers can both be processed in vacuum. Vacuum deposition is a well-established technique widely used in industrial semiconductor thin-film manufacturing such as for organic light emitting diodes (OLEDs) or light absorbing organic photovoltaic elements (OPVs). Advantageously, the combination of a perovskite subcell and an organic subcell increases the power conversion efficiency (PCE) of a tandem cell, wherein in particular the voltage of the perovskite subcell is equal to the voltage of the organic subcell. The limited absorption range of the organic subcell has the consequence that the overlap area to the perovskite subcell is small, which simplifies the optimization of the tandem cell with respect to their total current, since there is only limited influence between the subcells. The combination of the described materials and the thin layers makes industrial production possible in a closed vacuum process at reasonable processing speed.

According to a development of the invention, the at least one donor of the second photoactive layer is a small molecule having a defined molecular structure and a molar mass of 100 g/mol to 1200 g/mol, preferably 100 g/mol to 1000 g/mol, or preferably 100 g/mol to 800 g/mol.

In the context of the present invention 'small molecules' are in particular understood to be non-polymeric organic molecules having a defined molecular structure and a defined molar mass. Such "small molecules" are free of undefined, possible reactive groups at the end of the molecular chain and show ability to vaporize in vacuum and the associated possibility of purification by gradient sublimation, as one result layers comprising small molecules can be deposited by vacuum deposition.

According to a development of the invention, the wide band-gap of the first photoactive layer is more than 1.7 eV, preferably more than 1.8 eV, or preferably more than 1.9 eV, and/or the narrow band-gap of the second photoactive layer is less than 1.6 eV, preferably less than 1.4 eV, or preferably less than 1.2 eV, and/or the wide band-gap of the first photoactive layer is at least 0.2 eV, preferably at least 0.3 eV, or preferably at least 0.4 eV, larger compared to the narrow band-gap of the second photoactive layer.

According to a development of the invention, the first photoactive layer absorbs at least in the blue-green spectral range, preferably at least in the blue-green-red spectral range, preferably in a range from 400 nm to 700 nm, more preferably in a range from 400 nm to 650 nm, and the second photoactive layer absorbs at least in the red and near infrared spectral range, preferably in a range from 600 nm to 2500 nm, more preferably in a range from 600 nm to 1000 nm.

According to a development of the invention, the first photoactive layer and the second photoactive layer form an integrated perovskite/organic solar cell stack architecture (IPOSC), wherein the first photoactive layer is directly arranged at the second photoactive layer. Integrated perovskite/organic solar cells (IPOSC) combine perovskite and organic photoactive layers in a single device, wherein narrow band-gap organic photovoltaic materials are directly arranged on the wide band-gap perovskite without the presence of a recombination layer.

According to a development of the invention, the first photoactive layer is part of a first subcell and the second photoactive layer is part of a second subcell, wherein preferably the first subcell and the second subcell each are formed as a nip cell or a pin cell comprising an n-type layer, a photoactive layer, and a p-type layer. In a preferred embodiment the first subcell and the second subcell each are formed as a nip cell. In a preferred embodiment the n-type sublayer of the first subcell and or the second subcell is facing the first electrode. In a preferred embodiment the first photoactive layer is directly arranged at the n-type layer.

In a preferred embodiment the first subcell comprises the following layer sequence: n-type layer(ETL)/first photoactive layer/p-type layer(HTL), or n-doped n-type layer (n-ETL)/n-type layer(ETL)/first photoactive layer/p-type layer(HTL)/p-doped p-type layer (p-HTL).

In a preferred embodiment the second subcell comprises the following layer sequence: n-type layer(ETL)/second photoactive layer/p-type layer(HTL), or n-doped n-type layer(n-ETL)/n-type layer(ETL)/second photoactive layer/p-type layer(HTL)/p-doped p-type layer(p-HTL).

According to a development of the invention, the second subcell is formed as a BHJ, BHJ², BHJ+, PHJ, or PHJ-cascade cell. In the context of the present invention a BHJ (bulk-heterojunction) cell is an organic sub-cell comprising a donor-acceptor blended layer. In the context of the present invention a BHJ² cell is an organic sub-cell comprising two donor-acceptor blended layers directly attached to each other, wherein the two layers differ at least in the donor-material or the acceptor-material. In the context of the present invention a BHJ+ cell is an organic sub-cell comprising a donor-acceptor blended layer and directly attached at least one intrinsic donor or one intrinsic acceptor layer. In the context of the present invention a PHJ (planar heterojunction) cell is an organic sub-cell comprising an intrinsic acceptor layer and an intrinsic donor layer directly attached to each other. In the context of the present invention a PHJ-cascade cell is an organic subcell comprising an acceptor layer directly attached to at least two donor layers having different potentials, or a donor layer directly attached to at least two acceptor layers having different potentials. In a preferred embodiment the second photoactive layer is formed as planar heterojunction (PHJ), or the second photoactive layer is formed as bulk heterojunction (BHJ).

According to a development of the invention, the n-type layer is formed by an intrinsic n-type sublayer and/or an n-doped n-type sublayer, and/or the p-type layer is formed by an intrinsic p-type sublayer and/or a p-doped p-type sublayer, wherein preferably at least one intrinsic n-type sublayer and/or at least one intrinsic p-type sublayer is directly arranged at the first subcell and/or the second subcell.

In a preferred embodiment the p-type layer is a non-doped p-type layer, preferably hole transport material (HTM), and/or a doped p-type layer, preferably a hole transport material (HTM) and a p-dopant. In a preferred embodiment the n-type layer is a non-doped n-type layer, preferably electron transport material (ETM), and/or a doped n-type layer, preferably electron transport material (ETM) and an n-dopant. Preferably the absolute value of the HOMO of the n-dopant should be at least equal to the absolute value of the LUMO of the corresponding n-type layer plus 0.2 eV or smaller to allow for efficient n-doping. Preferably the absolute value of the LUMO of the p-dopant should be at least equal to the absolute value of the HOMO of the corresponding p-type layer minus 0.2 eV or larger to allow for efficient p-doping.

HOMO- and LUMO-energy levels can be determined from the redox potentials of the molecules, for which measurement methods are sufficiently described in the literature. The measurement by Cyclovoltammetry is described by Lucia Leonat et al. (U.P.B. Sci. Bull., Series B, Vol. 75, Iss. 3, 2013). Alternatively, HOMO and LUMO energies or the corresponding ionization energies and electron affinities can be determined from photoelectron spectroscopy and inverse photoelectron spectroscopy.

HOMO- and LUMO-energy levels were calculated alternatively based on the B3LYP method of the program Gaussian 98 (Gaussian, Inc., Pittsburgh, PA). The base set of the B3LYP method was defined as MIDI! for all available atoms and 6-31G* for all remaining atoms. The relative HOMO values calculated in this way were related to the material N,N'-Diphenyl-N,N-bis(3-methylphenyl)-1,1'-biphenyl-4,4'-diamine (TPD) studied in the literature, which has a ionization energy of 5.3 eV (C. Adachi et al, Appl. Phys. Lett. 66, 2679-2681 (1995)). Fullerene C60 has an electron affinity of 4.0 eV (W. Zhao, A. Kahn, Charge transfer at n-doped organic-organic heterojunctions, J. Appl. Phys., 105 (12) (2009) 123711).

In a preferred embodiment the n-type layer, in particular the intrinsic n-type sublayer, is formed by a fullerene or a fullerene derivative as electron transport material (ETM), preferably selected from the group consisting of C60, C70, C76, C80, C82, C84, C86, C90 und C94, or a derivative thereof, more preferably fullerene C60.

In a preferred embodiment the perovskite absorber material is an all-inorganic perovskite, preferably a three-dimensional halide perovskite, a double perovskite, or a combination thereof. Preferably the three-dimensional halide perovskite having a formula ABX₃, wherein A is selected from Cs, Na, K, Rb, or a combination thereof; B is selected from Pb, Sn, Ge, Cu, Fe, Ga, Eu, Sr, Ti, Mn, Bi, Zn, Mg, Ca, Ba, Y, Yb, Co, In, Sb, Bi, Ag, Ni, Ho, Er, Tb, Sm, La, or a combination thereof; and X is selected from F, Cl, Br, I, or a combination thereof. Preferably the double perovskite having a formula A₂BCX₆, wherein A is selected from Cs, Rb, or combination thereof; B is selected from Cu, Ag, Hg, Au, or a combination thereof; C is selected from Sb, Bi, or a combination thereof; and X is selected from F, Cl, Br, I, or a combination thereof.

According to a development of the invention, the perovskite absorber material of the first photoactive layer is an inorganic perovskite, preferably an all-inorganic perovskite, preferably the all-inorganic perovskite is selected from the group consisting of CsPbI₃, CsPbBrI₂, CsPbBr₂I, CsPbBr₃, CsPbCl₂I, CsPbClI₂, CsPbCl₃, CsPbBr₂Cl, CsPbBrCl₂, CsPbBrClI, and mixtures thereof.

According to a development of the invention, the at least one acceptor of the second photoactive layer is a fullerene or fullerene derivate, wherein the fullerene or a fullerene is selected from the group consisting of C60, C70, C76, C80, C82, C84, C86, C90 und C94, or a derivative thereof, wherein the derivate preferably is a halogenated fullerene, a hydroxylated fulleren, a carboxylated fullerene, or an aminated fullerene, preferably the fullerene is C60, C70 and/or a derivate thereof, more preferably fullerene C60. In a preferred embodiment the acceptor is not a non-fullerene acceptor (NFA).

According to a development of the invention, the first photoactive layer is located at a side facing the light within the stack of the optoelectronic component as intended, preferably arranged at the first electrode, and the second photoactive layer is located at a side facing away from the light within the stack of the optoelectronic component as intended, preferably arranged at the second electrode. In the context of the present invention in the optoelectronic component the first electrode is located at a side of the optoelectronic component facing the light as intended.

Combining properly a wide band-gap perovskite subcell with a narrow band-gap organic subcell into a monolithic tandem or multijunction photovoltaic device is expected to produce higher output photovoltage than the all-organic-based counters without any detrimental effects on the short circuit current and fill factor, thus enhances the performance (PCE). Appropriate interconnecting layers (ICLs) between organic and perovskite subcells is one of the most critical and challenging tasks. The interconnecting layer connects the subcells serving as the carrier recombination zone, therefore determining the fill factor (FF), Voc and Jsc of the tandem device, and consequently the device performance. Furthermore, the durability of a multijunction photovoltaic device is affected by the interconnecting layers.

According to a development of the invention, first subcell and the second subcell are interconnected by an interconnecting unit forming a multijunction stack architecture. An interconnecting unit is understood to mean, in particular, a layer or a layer sequence between two photoactive layers or between to subcells each comprising a photoactive layer, which connects the photoactive layers in series. In particular, the interconnecting unit interconnects the first subcell and the second subcell in a way that photogenerated holes from one subcell can recombine with photogenerated electrons from the other subcell with low energetic loss. The interconnecting unit is a critical feature for connecting two subcells of a tandem cell with regard to the performance and the durability. By introducing the interconnecting unit, the stability of the optoelectronic component is further increased.

According to a development of the invention, the interconnecting unit comprises a p-type layer and an n-type layer arranged between the first photoactive layer and the second photoactive layer, preferably the n-type layer is formed by an intrinsic n-type sublayer and/or an n-doped n-type sublayer, and/or the p-type layer is formed by an intrinsic p-type sublayer and/or a p-doped p-type sublayer.

In the context of the present invention a p-type layer is, in particular, a layer comprising a hole transport material (HTM) or a layer comprising a hole transport material (HTM) and a p-dopant. The p-type layer is in particular a hole transport layer (HTL) and favors the transport of positive charge carriers (holes) of a photoactive layer to an electrode and/or between two photoactive layers.

In the context of the present invention an n-type layer is, in particular, a layer comprising an electron transport material (ETM) or a layer comprising an electron transport material (ETM) and an n-dopant. The n-type layer is in particular an electron transport layer (ETL).

According to a development of the invention, at least one intrinsic n-type sublayer and/or at least one intrinsic p-type sublayer is directly arranged at the first subcell and/or the second subcell.

According to a development of the invention, within the stack the p-type layer of the interconnecting unit is facing the first photoactive layer and the n-type layer of the interconnecting unit is facing the second photoactive layer.

According to a development of the invention, the interconnecting unit comprises an interlayer arranged between the n-type layer and the p-type layer, wherein the interlayer is an n-doped interlayer, a p-doped interlayer, a metal layer, preferably from Au or an alloy thereof or Cu or an alloy thereof, a metal oxide layer, preferably from InOx, SnOx, or MoOx, or a transparent conductive oxide (TCO) layer, preferably from ITO or AZO. In a preferred embodiment the interlayer is an ultrathin layer having a layer thickness of 2 nm to 10 nm, preferably 2 nm to 5 nm.

According to a development of the invention, the interconnecting unit comprises in sequence the following layers: a) a doped or non-doped p-type layer having a band-gap of more than 2.5 eV, wherein the p-type layer has an ionization energy of at least 5.0 eV; b) an n-doped interlayer comprising a matrix material and at least one n-dopant, wherein the n-doped interlayer has an electron affinity of more than 4.4 eV, preferably the n-dopant of the n-doped interlayer has a HOMO more negative than -4.6 eV, and wherein the ratio of the at least one dopant is 1 to 30 vol.-%; and c) a doped n-type layer comprising an electron transport material (ETM) and at least one n-dopant, wherein the n-type layer has an electron affinity of less than 4.4 eV.

In a preferred embodiment the p-type layer of the interconnecting unit has an ionization energy of more than 5.2 eV, preferably of more than 5.4 eV, preferably from 5.2 eV to 6.0 eV, or preferably from 5.2 to 5.6 eV.

In a preferred embodiment the hole transport material (HTM) of the p-type layer is selected from the group consisting of N4,N4,N4',N4'-Tetra[(1,1'-biphenyl)-4-yl]-(1,1'-biphenyl)-4,4'-diamine (BPBPA), N4,N4,N4",N4"-tetra([1,1'-biphenyl]-4-yl)-[1,1':4',1"-terphenyl]-4,4"-diamine (TaTm), N,N'-Bis(naphthalen-1-yl)-N,N'-bis(phenyl)-benzidine (a-NPD), MeO-TAD, Spiro-MeO-TAD, HTM081, TDATA-Derivate, N4,N4'-Bis (9,9-dimethyl-9H-fluoren-2-yl)-N4,N4'-diphenylbiphenyl-4,4'-diamine (BF-DPB), and N3,N3'-Di(biphenyl(-4-yl)-N3,N3'-dimesitylbiphenyl-3,3'-diamin (HT3).

In a preferred embodiment the p-dopant of the p-type layer of the interconnecting unit has a LUMO of less than -4.5 eV, preferably of less than -4.7 eV, preferably of less than -4.9 eV, preferably of less than -5.0 eV, or preferably of less than -5.1 eV. In a preferred embodiment the p-dopant of the p-type layer of the interconnecting unit is an organic dopant, preferably selected from the group consisting of NDP2, NDP9, C60-F36, and C60-F48. NDP2 and NDP9 are commercial p-dopants of Novaled GmbH.

In a preferred embodiment the p-type layer of the interconnecting unit comprises an organic material as hole transport material (HTM) alone or in combination with an organic p-dopant. Preferably the hole transport material is a tetraaryl-diamine-derivate having at least two amino-residues and in between at least two aryl-units, in particular a compound of general formula II 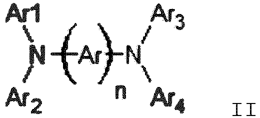 wherein Ar₁, Ar₂, Ar₃ and Ar₄ are independently form each other a non-substituted or substituted aryl-unit, Ar independently from each other a non-substituted or substituted aryl-unit, and n is at least 2, preferably is n = 2,3,4 or 5. Preferably the substituent of Ar1, Ar2, Ar3 and Ar4 is selected from the group consisting of a halogen, amino-group, preferably an amino-group substituted with two aryl-groups, alkyl-group, alkenyl-group, alkoxy-group, and aryl-group.

In a preferred embodiment the n-doped interlayer of the interconnecting unit has an electron affinity of more than 4.5 eV, preferably more than 4.6 eV, preferably more than 4.7 eV, preferably more than 4.8 eV, or preferably more than 4.9 eV, wherein preferably the ratio of the electron transport material in the n-doped interlayer is at maximal 98.5 vol.-%, preferably at maximum 98 vol.-%, preferably at maximum 97 vol.-%, preferably at maximum 96 vol.-%, or preferably at maximum 95 vol.-%.

In a preferred embodiment the electron transport material (ETM) of the n-doped interlayer of the interconnecting unit is a chemical compound of formula I 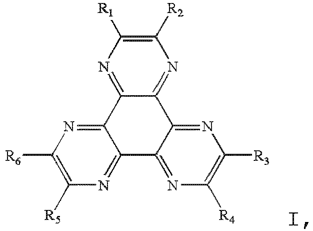 wherein R₁ to R₆ is H or a substituent selected from the group consisting of halogen, -CN, -NO₂, -SO₂R, -SOR, -CF₃,-COOR), -CONHR, -CONRR'), non-substituted or substituted aryl, non-substituted or substituted heteroaryl, and non-substituted or substituted alkyl, wherein R and R' are a non-substituted or substituted alkyl or aryl, or wherein R₁ and R₂, R₃ and R₄, or R₅ and R₆ together form a ring-structure, wherein the ring-structure is an aromatic ring, a heteroaromatic ring, or an aliphatic ring, which ring-structure can be non-substituted or substituted.

In a preferred embodiment the electron transport material (ETM) of the n-doped interlayer of the interconnecting unit is selected from the group consisting of Hexaazatriphenylen, preferably having six electron-withdrawing substituents, preferably Dipyrazino[2,3-f:2`,3`-h]quinoxaline-2,3,6,7,10,11-hexacarbonitril (CN-HAT), Tetracyanobenzochinondimethan (TCNQ), Tetracyanonaphthochinondimethan (TCNNQ), Radialene, and derivatives of each.

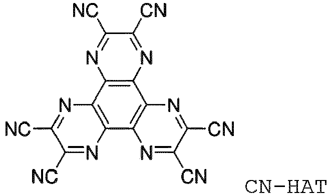

In a preferred embodiment the n-dopant of the n-doped interlayer has a HOMO more negative than -4.6 eV, preferably more negative than -4.8 eV, or preferably more negative than -5.0 eV.

In a preferred embodiment the ratio of the n-dopant in the n-doped interlayer is 1 to 30 vol.-%, preferably 1 to 20 vol.-%, preferably 1 to 10 vol.-%, preferably 1 to 5 vol.-%, preferably 2 to 30 vol.-%, preferably 5 to 30 vol.-%, preferably 2 to 20 vol.-%, preferably 2 to 10 vol.-%, preferably 2 to 5 vol.-%, preferably 3 to 30 vol.-%, preferably 3 to 20 vol.-%, preferably 5 to 20 vol.-%, preferably 3 to 10 vol.-%, or preferably 3 to 5 vol.-%.

In a preferred embodiment the n-dopant of the n-doped interlayer of the interconnecting unit has an ionization energy of 4.8 eV to 5.4 eV, preferably of 5.0 to 5.4 eV, preferably of 4.8 to 5.2 eV, or preferably of 5.0 to 5.2 eV.

In a preferred embodiment the n-dopant of the n-doped interlayer of the interconnecting unit is selected from the group consisting of Pentacen or derivatives thereof, TDATA or derivatives thereof, preferably m-MTDATA , TAD or derivatives thereof, preferably Spiro-MeO-TAD, BPBPA or derivatives thereof, TNATA or derivatives thereof, preferably 2-TNATA, TPD or derivatives thereof, preferably MeO-TPD, and Triarylamine-derivatives having at least one alkyl- or alkoxy- substituents at at least two aryl-groups of the amine. Preferably the n-dopant of the n-doped interlayer is an organic material.

In a preferred embodiment the n-type layer of the interconnecting unit has an electron affinity of less than 4.2 eV, preferably of less than 4.0 eV, wherein preferably the electron transport material of the n-type layer is selected from the group consisting of a fullerene or a fullerene derivative, in particular fullerene C60, NTCDA, TNATA, and NTCDI or a derivative thereof.

In a preferred embodiment the n-dopant of the n-type layer of the interconnecting unit has a HOMO more positive than -5.0 eV, preferably more positive than -4.8 eV, or preferably more positive than -4.7 eV. Preferably the n-dopant of the n-type layer is an organic n-dopant, preferably selected from the group consisting of 2,2'-Diisopropyl-1,1',3,3'-tetramethyl-2,2',3,3',4,4',5,5',6,6',7,7'-dodecahydro-2,2'- bibenzo[d]imidazol (NDR-1); 4,4',5,5'-Tetracyclohexyl-1,1',2,2',3,3'-hexamethyl-2,2',3,3'-tetrahydro-2,2'-biimidazol (NDR-2); 2,2'-diisopropyl-4,4',5,5'-tetrakis(2-methoxyphenyl)-1,1',3,3'-tetramethyl-2,2',3,3'-tetrahydro-1H,1'H-2,2'-biimidazol (NDR-3); 2,2'-diisopropyl-1,1',3,3'-tetramethyl-2,2',3,3'-tetrahydro-1H,1'H-2,2'-bibenzo[d]imidazol (NDR-4); 2,2'-diisopropyl-4,4',5,5'-tetrakis(3-methoxyphenyl)-1,1',3,3'-tetramethyl-2,2',3,3'-tetrahydro-1H,1'H-2,2'-biimidazol (NDR-5); 2-Isopropyl-1,3-dimethyl-2,3,6,7-tetrahydro-5,8-dioxa-1,3-diaza-cyclopenta[b]naphthene; Bis-[1,3-dimethyl-2-isopropyl-1,2-dihydro-benzimidazolyl-(2)]; 2,2'-Diisopropyl-4,5-bis (2-methoxyphenyl)-4',5'-bis(4-methoxyphenyl)-1,1',3,3'-tetramethyl-2,2',3,3'-tetrahydro-2,2'-biimidazol; and NDN45.

In a preferred embodiment the electron affinity of the n-doped interlayer differs from the electron affinity of the n-type layer by at least 0.5 eV, preferably by at least 0.6 eV, or preferably by at least 0.7 eV.

In a preferred embodiment the ionization energy of the p-type layer differs from the ionization energy of the n-doped interlayer by more than 0.3 eV and less than 1.0 eV, preferably by more than 0.5 eV and less than 0.8 eV.

In a preferred embodiment the p-dopant of the p-type layer of the interconnecting unit is selected from the group consisting of 2,2'-(perfluorocyclohexa-2,5-diene-1,4-diylidene)dimalononitril (TCNQ-1), N'-Dicyan-2,3,5,6-tetrafluoro-1,4-chinondiimin; N,N'-Dicyan-2,5-dichloro-1,4-chinondiimin, N,N'-Dicyan-2,5-dichloro-3,6-difluoro-1,4-chinondiimin, N,N'-Dicyan-2,3,5,6,7,8-hexafluoro-1,4-naphthochinondiimin, 1,4,5,8-Tetrahydro-1,4,5,8-tetrathia-2,3,6,7-tetracyano-anthrachinon, 1,3,4,5,7,8-Hexafluoronaphtho-2,6-chinontetracyanomethan (TCNQ-7), 2,2'-(2,5-Dibrom-3,6-difluorcyclobexa-2,5-dien-1,4-diyliden)dimalononitril, 4,4'-(1E,1'E)-(2-cyano-3,6-difluoro-5-isocyanocyclohexa-2,5-diene-1,4-diylidene)bis-(cyanomethan-1-yl-1-ylidene)bis(2,3,5,6-tetrafluorobenzonitril), 2,2',2"- (Cyclopropan-1,2,3 - triyliden)tris(2-(2,6-dichlor-3,5-difluor-4-(trifluormethyl)phenyl)acetonitril), (2E,2'E,2"E)-2,2',2"-(cyclopropane-1,2,3-triylidene)tris(2-(perfluorophenyl)acetonitril), 2,2',2"-(cyclopropane-1,2,3-triylidene)tris(2-(perfluorobiphenyl-4-yl)acetonitril), 2,2',2"-(cyclopropane-1,2,3-triylidene)tris(2-(2,6-dichloro-3,5-difluoro-4-(trifluoromethyl)phenyl)-acetonitril), and Benzene-acetonitril, α,α',α"-1,2,3-cyclopropanetriylidenetris[4-cyano-2,3,5,6-tetrafluoro-(PR-1).

In a preferred embodiment at least one layer of the interconnecting unit comprises an organic material, preferably all layers of the interconnecting unit comprise an organic material.

In a preferred embodiment the interconnecting unit comprises an n-doped interlayer and a p-doped interlayer which form a tunnel-junction between the n-type layer and the p-type layer, preferably a further metal interlayer and/or a metal oxide interlayer is arranged between the n-doped interlayer and the p-doped interlayer, wherein the metal oxide layer is arranged at the n-doped interlayer, or a further transparent conductive oxide (TCO) and/or a metal oxide layer, wherein the metal oxide layer is arranged at the n-doped interlayer.

In a preferred embodiment the interconnecting unit is formed by a hole transport layer (HTL) and an ambipolar organic layer acting as recombination layer, said ambipolar organic layer being arranged at the second photoactive layer, where electrons and holes extracted from the adjacent photoactive layers recombine.

According to a development of the invention, the stack comprises a third photoactive layer, wherein the third photoactive layer comprises at least one perovskite absorber material or is an organic photoactive layer having a narrow band-gap comprising at least one donor and at least one acceptor as organic absorber materials forming a donor/acceptor heterojunction, preferably the third photoactive layer is part of a third subcell. In a preferred embodiment the third subcell is a BHJ, BHJ2, BHJ+, PHJ, or PHJ-cascade cell. In a preferred embodiment the stack architecture is a triple junction consisting of three subcells, wherein the perovskite absorber material of the third subcell is an all-inorganic perovskite absorber material. In a preferred embodiment the stack architecture is a triple junction, wherein the at least one acceptor as organic absorber material of the third subcell is an A-D-A and/or BODIPY compound.

In a preferred embodiment the sequence of the photoactive layers starting from the light-facing side of the optoelectronic component is the first photoactive layer, the second photoactive layer and the third photoactive layer. In an alternative preferred embodiment the sequence of the photoactive layers starting from the light-facing side of the optoelectronic component is the first photoactive layer, the third photoactive layer and the second photoactive layer. In another alternative embodiment, in case of a triple cell, the first photoactive layer is sandwiched between the second photoactive layer and the third photoactive layer, both comprising organic absorber materials.

In an alternative preferred embodiment the first photoactive layer and the second photoactive layer form an integrated perovskite/organic solar cell stack architecture (IPOSC), and the third photoactive layer is part of a subcell comprising organic absorber materials, wherein at least one donor and at least one acceptor as organic absorber materials are forming a donor/acceptor heterojunction, preferably the at least one donor of the second photoactive layer is an A-D-A compound and/or a BODIPY compound.

According to a development of the invention, the optoelectronic component is a photovoltaic element or a photodetector, preferably the optoelectronic component is a flexible photovoltaic element. A photovoltaic element is in particular a solar cell. The photovoltaic element is preferably composed of a plurality of photovoltaic cells, which may be connected in series or in parallel. A flexible optoelectronic component is understood to mean, in particular, an optoelectronic component which is bendable and/or extensible in a specific region. In a preferred embodiment the substrate is flexible and/or the stack of the optoelectronic component is flexible.

In a preferred embodiment at least the photoactive layers are vacuum deposited, preferably all the layers of the stack are vacuum deposited.

### Description of the Drawings

The invention is described in more detail with reference to working examples and figures. The working examples are intended to describe the invention without restricting it. It can be demonstrated that for photovoltaic elements an organic subcell can combined with a perovskite subcell to a tandem cell so to improve the efficiency of each corresponding single cell, in particular by substituting an organic subcell of an organic tandem cell by a perovskite subcell. It can be further demonstrated that organic subcells can be combined with perovskite subcells to tandem cells so to improve the durability of such tandem cells.

Donor1 and Donor2 are BODIPY compounds. In all figures, identical and functionally identical elements are provided with the same reference signs, so that in this respect reference is made to the preceding description.
Fig. 1 shows a schematic illustration of an exemplary embodiment of an optoelectronic component with a perovskite subcell and an organic subcell with an interconnecting unit in cross-section;
Fig. 2 shows a schematic illustration of an exemplary embodiment of an optoelectronic component with a perovskite subcell and an organic subcell with an interconnecting unit comprising an n-doped interlayer in cross-section;
Fig. 3 shows a schematic illustration of an exemplary embodiment of an optoelectronic component with a perovskite photoactive layer and a directly arranged organic photoactive layer in cross-section;
Fig. 4 shows a schematic illustration of an exemplary embodiment of an optoelectronic component with a perovskite subcell and two organic subcells in cross-section;
Fig. 5 shows in one embodiment the current-voltage curve of an optoelectronic component formed as tandem cell comprising donor 1;
Fig. 6 shows in one embodiment the current-voltage curve of an optoelectronic component formed as tandem cell comprising donor 2; and
Fig. 7 shows in one embodiment shelf-life data of an optoelectronic component with a perovskite photoactive layer, an organic photoactive layer and an interconnecting unit in between.

### Working examples

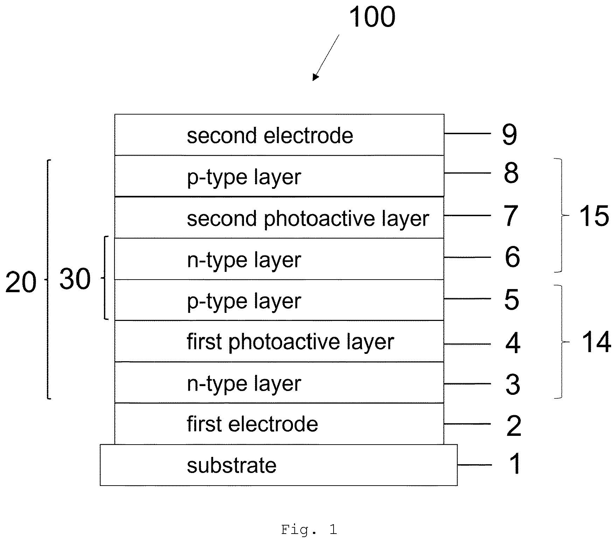

Fig. 1 shows a schematic illustration of an exemplary embodiment of an optoelectronic component 100 with a perovskite subcell 14 and an organic subcell 15 with an interconnecting unit 30 in cross-section. The layer thickness and the ratio of the layer thicknesses to each other do not correspond to the actual dimensions.

The optoelectronic component 100, preferably photovoltaic element with at least one photovoltaic cell, comprising a first electrode 2, a second electrode 9, and a stack 20 arranged between the first electrode 2 and the second electrode 9, the stack 20 comprising at least a first photoactive layer 4 and a second photoactive layer 7, wherein the first photoactive layer 4 comprises at least one perovskite absorber material having a wide band-gap, and the second photoactive layer 7 is an organic photoactive layer having a narrow band-gap comprising at least one donor and at least one acceptor as organic absorber materials forming a donor/acceptor heterojunction. The at least one donor of the second photoactive layer 7 is a A-D-A compound and/or a BODIPY compound. In this example, the optoelectronic component 100 is a photovoltaic element. In particular, this results in improved efficiency and improved lifetime of the photovoltaic element.

In an exemplary embodiment, the photovoltaic element comprises a substrate 1, in particular a flexible substrate, e.g. a PET film, alternatively a rigid substrate 1, e.g. glass, with transparent ITO (indium-tin-oxide) as first electrode 2. In an alternative embodiment the first electrode 2 can be formed of a metal, in particular Al, Ag, Au or a combination thereof, another conductive oxide, in particular ZnO:Al, or a conductive polymer, in particular PEDOT:PSS (Poly(3,4-ethylenedioxythiophene)-poly(sytrenesulfonate) or PANI (Polyanilin). A layer of fullerene C60 as n-type layer 3 (electron transport layer, ETL), a first photoactive layer 4 of an inorganic perovskite, e.g. CsPbI₂Br, and a p-type layer 5 of TaTm form the first subcell 14. An interconnecting unit 30 is arranged between the first photoactive layer 4 and the second photoactive layer 7. The interconnecting unit 30, formed as pn-junction, is constructed from a p-doped p-type layer 5, e.g. TaTm doped with NDP9, followed by an n-doped n-type layer 6, e.g. C60 doped with NDN45. On the interconnecting unit 30 arranged is a second subcell 15, formed by a layer of fullerene C60 as n-type layer 6 (electron transport layer, ETL), a second photoactive layer 7 of organic donor material and acceptor material, either as a planar heterojunction (PHJ), wherein the acceptor layer is separated from the donor layer, or as a bulk heterojunction (BHJ), wherein the acceptor and the donor are blended, and a p-type layer 8, e.g. of HHT036.

In a first working example the second photoactive layer 7 is formed as PHJ cell having an acceptor layer of C60 (15 nm) and a donor layer of donor 1 (15 nm). In a second working example the second photoactive layer 7 is formed as PHJ cell having an acceptor layer of C60 (15 nm) and a donor layer of donor 2 (12 nm). Each on top is a p-doped p-type layer 8 (HTL), e.g. HHT036 doped with NDP9, and a second electrode 9 made of Au or Al. The stack architecture of such an optoelectronic component 100 is described in table 1 and table 2, respectively. The layer thickness of the first photoactive layer 4 and of the second photoactive layer 7 was adapted for current matching. Alternatively, the second photoactive layer can by formed as BHJ cell comprising a blend of the donor and the acceptor, e.g. donor 1 and C60 1:1.

In these exemplary embodiments the subcells 14,15 are constructed as n-i-p structures. In an alternative embodiment the subcells 14,15 can be constructed as p-i-n structures. In this context n-type layers are electron transport layers and p-type layers are hole transport layers, each might be n-doped or p-doped, respectively, which lead to an increase in density of free electrons or holes in the thermal equilibrium state. The i-layer (intrinsic layer) refers to an undoped layer, in particular a photoactive layer 4,7.

The structure of the photovoltaic element in the first working example is shown in table 1:

**Table 1**

| **layer** | **material** | **thickness / nm** |
|---|---|---|
| second electrode 9 | Au | 50 |
| p-doped p-type layer 8 | HHT036/NDP9 (10 wt.-%) | 40 |
| p-type layer 8 | HHT036 | 10 |
| second photoactive layer 7 | donor 1 | 15 |
| second photoactive layer 7 | acceptor C60 | 15 |
| n-type layer 6 | C60 | 9 |
| n-doped n-type layer 6 | C60:NDN45 (20 wt.-%) | 5 |
| p-doped p-type layer 5 | TaTm/NDP9 (10 wt.-%) | 30 |
| p-type layer 5 | TaTm | 10 |
| first photoactive layer 4 | perovskite CsPbI₂Br | 110 |
| n-type layer 3 | C60 | 15 |
| first electrode 2 | ITO | 100 |

| | | |
|---|---|---|
| ITO: indium tin oxide NDP9: commercial p-dopant of Novaled GmbH TaTm: N4,N4,N4",N4"-tetra([1,1'-biphenyl]-4-yl)-[1,1':4',1"-terphenyl]-4,4"-diamine NDN45: commercial n-dopant of Novaled GmbH HHT036: N3,N3'-Di(biphenyl(-4-yl)-N3,N3'-dimesitylbiphenyl-3,3'-diamin | | |

### donor 1:

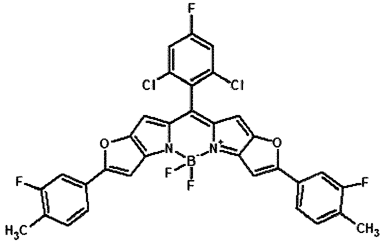

The structure of the photovoltaic element in a second working example is shown in table 2:

**Table 2**

| **layer** | **material** | **thickness / run** |
|---|---|---|
| second electrode 9 | Au | 50 |
| p-doped p-type layer 8 | HHT036/NDP9 (10 Gew.-%) | 40 |
| p-type layer 8 | HHT036 | 10 |
| second photoactive layer 7 | donor 2 | 12 |
| second photoactive layer 7 | acceptor C60 | 15 |
| n-type layer 6 | C60 | 9 |
| n-doped n-type layer 6 | C60:NDN45 (20 Gew.-%) | 5 |
| p-doped p-type layer 5 | TaTm/NDP9 (10 Gew.-%) | 30 |
| p-type layer 5 | TaTm | 10 |
| first photoactive layer 4 | perovskite CsPbI₂Br | 150 |
| n-type layer 3 | C60 | 15 |
| first electrode 2 | ITO | 100 |

| | | |
|---|---|---|
| ITO: indium tin oxide NDP9: commercial p-dopant of Novaled GmbH TaTm: N4,N4,N4",N4"-tetra([1,1'-biphenyl]-4-yl)-[1,1':4',1"-terphenyl]-4,4"-diamine NDN45: commercial n-dopant of Novaled GmbH HHT036: N3,N3'-Di(biphenyl(-4-yl)-N3,N3'-dimesitylbiphenyl-3,3'-diamin | | |

### donor 2:

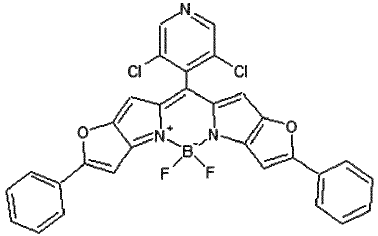

The stack 20, in particular individual layers, and the electrode 9 of the optoelectronic component 100 can be produced by vacuum deposition of the compounds. The substrate 1 can be a flexible substrate, e.g. a film from PET. The layers can be deposited in a roll-to-roll process.

Preparation of the photovoltaic element: The perovskite subcell 14 and the organic subcell 15 of the tandem device were manufactured by thermal evaporation processes in chambers kept under high vacuum, typically at/below 10⁻⁷ mbar. Vacuum deposition of the individual layers of the stack 20 as well as the electrode 9 was used to manufacture the photovoltaic element. The substrate 1 with the first electrode 2 is provided. The layers of the stack 20 are formed step by step one after the other.

Perovskite subcell 14 comprising the first photoactive layer 4, and interconnecting unit 30: For the perovskite subcell 14 a layer of C60 (15 nm) was deposited at a deposition rate of 0.2 to 0.3 Å/s on an ITO (100 nm) layered glass substrate patterned with an active area of 6.4 mm² to create an n-type layer 3 as electron transport layer (ETL). An all-inorganic CsPbI₂Br perovskite photoactive layer 4 was subsequently formed on the n-type layer 3 by co-evaporating two precursors, a first precursor CsBr and a second precursor PbI₂, at deposition rates of 0.2 Å/s and 0.31 Å/s, respectively. The thickness of the perovskite photoactive layer 4 was adjusted in a range of 100 to 150 nm to match the current to be delivered by the organic subcell 15. A layer of TaTm (10 nm) material was applied at a deposition rate of 0.3 Å/s on the top of the perovskite photoactive layer 4 to act as p-type layer 5 as hole transport layer (HTL). Subsequently, the interconnecting unit 30 to connect the perovskite subcell 14 with the organic subcell 15 was applied. The interconnecting unit 30 was formed by co-evaporating TaTm as HTM and NDP9 as p-dopant in a ratio of 10 wt.-% (30 nm) to form a p-doped p-type layer 5 (p-HTL), and by co-evaporating C60 as ETM and NDN45 as n-dopant in a ratio of 20 wt.-% (5 nm) to form an n-doped n-type layer 6 (n-ETL) at a deposition rate of 1.0 Å/s. Deposition of the layers at higher deposition rate or lower deposition rate is possible, preferably in the range of 0.1 to 10 Å/s. In an alternative embodiment additionally an ultrathin layer of Au was deposited between the p-doped p-type layer 5 and the n-doped n-type layer 6, or an n-doped interlayer 10 was deposited between the p-doped p-type layer 5 and the n-doped n-type layer 6.

Organic subcell 15 comprising the second photoactive layer 7: The substrate 1 with the applied perovskite subcell 14 and the interconnecting unit 30 was transferred to another vacuum chamber to prepare the organic subcell 15. The organic subcell 15 was applied on the interconnecting unit 30. The organic subcell 15 is formed as PHJ (planar heterojunction) cell or as BHJ (bulk heterojunction) cell. In case of the PHJ cell (table 2) on the interconnecting unit 30 a layer of C60 (9 nm) was deposited with a deposition rate of 0.2 Å/s to construct the n-type layer 6 of the organic subcell 15 and a layer of C60 (15 nm) to construct the acceptor layer of the second photoactive layer 7. In the present example the n-type layer 6 and the acceptor layer of the second photoactive layer 7 are of the same material. An organic absorber layer of donor 2 (12 nm) was then applied on the acceptor layer at a deposition rate of 0.3 Å/s to construct a donor layer of the organic subcell 15. Alternatively in case of the BHJ cell (table 1) on the interconnecting unit 30 a layer of C60 (9 nm) was deposited with a deposition rate of 0.2 Å/s to construct the n-type layer 6 (ETL) of the organic subcell 15. The organic absorber layer can be formed as BHJ of donor 1 as donor and C60 as acceptor (20 nm) applied on the n-type layer 6 (ETL) at a deposition rate of 0.3 Å/s by co-evaporating donor 1 and C60 (1:1) to construct the second photoactive layer 7 of the organic subcell 15. In both working examples the donors, donor 1 and donor 2, of the second photoactive layer 7 are small molecules having a defined molecular structure and a molar mass of 100 g/mol to 1000 g/mol.

To facilitate the hole transport towards the second electrode 9 an intrinsic p-type layer 8 (HTL) of HHT036 (10 nm) followed by a p-doped p-type layer 8 (p-doped HTL) of HHT036 doped with NDP9 10 wt.-% (40 nm) was applied. Finally, a layer of Au (50 nm) was deposited at a deposition rate of 1.0 Å/s as second electrode 9. In this example, the complete stack 20 including electrode 9 was processed in a roll-to-roll process. In an alternative embodiment additionally an ultrathin layer of the p-dopant NDP9 (1 nm) was utilized to optimize the electrical contact between the p-doped p-type layer 8 and the second electrode 9. No heating was applied to the substrate 1 during the process. The temperature of the substrate 1 during the process was 30°C.

In this exemplary embodiment the perovskite absorber material of the first photoactive layer 4 is an all-inorganic perovskite. The first photoactive layer 4 is part of a first subcell 14 and the second photoactive layer 7 is part of a second subcell 15, wherein preferably the first subcell 14 and the second subcell 15 each are formed as a nip cell or a pin cell comprising an n-type layer 3,6, a photoactive layer 4,7, and a p-type layer 5,8. The n-type layer 6 is formed by an intrinsic n-type sublayer and an n-doped n-type sublayer, and the p-type layer 5 is formed by an intrinsic p-type sublayer and a p-doped p-type sublayer, wherein one intrinsic n-type sublayer is directly arranged at the first subcell 14 and one intrinsic p-type sublayer is directly arranged at the second subcell 15.

In this exemplary embodiment the interconnecting unit 30 comprises a p-type layer 5 and an n-type layer 6 arranged between the first photoactive layer 4 and the second photoactive layer 7, the p-type layer 5 of the interconnecting unit 30 is formed by a p-doped p-type sublayer, and the n-type layer 6 of the interconnecting unit 30 is formed by an n-doped n-type sublayer. The p-type layer 5 of the interconnecting unit 30 is facing the first photoactive layer and the n-type layer 6 of the interconnecting unit 30 is facing the second photoactive layer 7.

In a further embodiment of the invention the wide band-gap of the first photoactive layer 4 is more than 1.7 eV, preferably more than 1.8 eV, or preferably more than 1.9 eV, and/or the narrow band-gap of the second photoactive layer 7 is less than 1.6 eV, preferably less than 1.4 eV, or preferably less than 1.2 eV, and/or the wide band-gap of the first photoactive layer 4 is at least 0.2 eV, preferably at least 0.3 eV, or preferably at least 0.4 eV, larger compared to the narrow band-gap of the second photoactive layer 7.

In a further embodiment of the invention the first photoactive layer 4 absorbs at least in the blue-green spectral range, preferably in a range from 400 nm to 700 nm, more preferably in a range from 400 nm to 650 nm, and the second photoactive layer 7 absorbs in the red and near infrared spectral range, preferably in a range from 600 nm to 2500 nm, more preferably in a range from 600 nm to 1000 nm.

In a further embodiment of the invention the first photoactive layer 4 is located at a side facing the light within the stack 20 of the optoelectronic component 100 as intended, preferably arranged at the first electrode 2, and the second photoactive layer 7 is located at a side facing away from the light within the stack 20 of the optoelectronic component 100 as intended, preferably arranged at the second electrode 9.

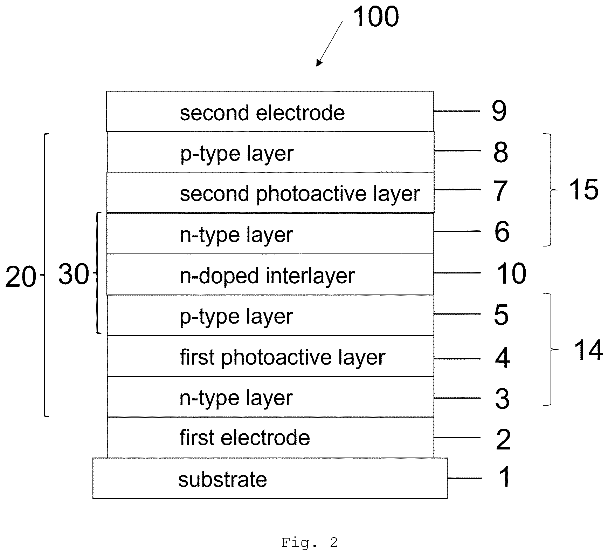

Fig. 2 shows a schematic illustration of an exemplary embodiment of an optoelectronic component 100 with a perovskite subcell 14 and an organic subcell 15 with an interconnecting unit 30 comprising an n-doped interlayer 10 in cross-section. In this exemplary embodiment the optoelectronic component 100 is a photovoltaic element.

In a further embodiment of the invention the interconnecting unit 30 comprises an interlayer 10 arranged between the n-type layer 6 and the p-type layer 5, wherein the interlayer 10 is an n-doped interlayer, a p-doped interlayer, a metal layer, preferably from Au or an alloy thereof or Cu or an alloy thereof, a metal oxide layer, preferably from InOx, SnOx, or MoOx, or a transparent conductive oxide (TCO) layer, preferably from ITO or AZO.

In a further embodiment of the invention the interconnecting unit 30 comprises in sequence the following layers: a) a doped or non-doped p-type layer 5 having a band-gap of more than 2.5 eV, wherein the p-type layer 5 has an ionization energy of at least 5.0 eV; b) an n-doped interlayer 10 comprising a matrix material and at least one n-dopant, wherein the n-doped interlayer 10 has an electron affinity of more than 4.4 eV, preferably the n-dopant of the n-doped interlayer 10 has a HOMO more negative than -4.6 eV, and wherein the ratio of the at least one dopant is 1 to 30 vol.-%; and c) a doped n-type layer 6 comprising an electron transport material (ETM) and at least one n-dopant, wherein the n-type layer 6 has an electron affinity of less than 4.4 eV.

In this exemplary embodiment the stack 20 is substantially the same compared to Fig. 1, wherein between the p-type layer 5 and the n-type layer 6 of the interconnecting unit 30 an n-doped interlayer 10 is arranged. The p-type layer 5 of the interconnecting unit 30 is p-doped comprising the matrix material TaTm (ionization energy of 5.4 eV) and 10 wt.% of the p-dotand NDP9 (LUMO of 5.4 eV). The n-doped interlayer 10 comprises CN-HAT (electron affinity 5.0 eV) as matrix material and 20 wt.-% of the n-dopant TNATA (ionization energy 5.0 eV). The n-type layer 6 of the interconnecting unit 30 is n-doped comprising C60 (electron affinity of 4.0 eV) as matrix material and 20 wt.-% of the n-dopant NDN45 (HOMO of -4.56 eV).

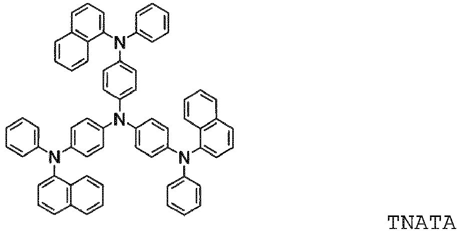

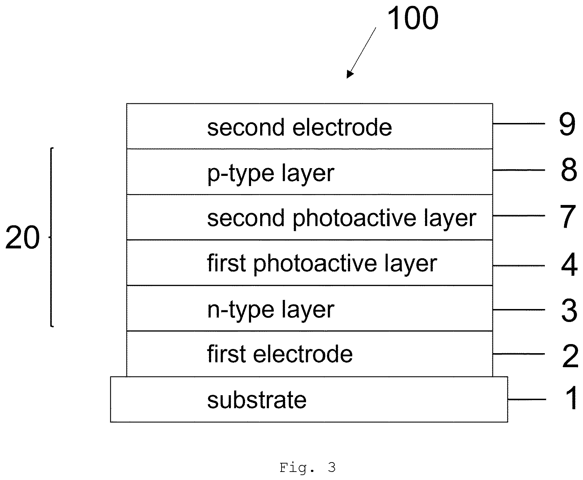

Fig. 3 shows a schematic illustration of an exemplary embodiment of an optoelectronic component 100 with a perovskite photoactive layer 4 and a directly arranged organic photoactive layer 7 in cross-section. In this exemplary embodiment the optoelectronic component 100 is a photovoltaic element.

In this exemplary embodiment the stack 20 is substantially the same compared to Fig. 1, wherein the first photoactive layer 4 which is a perovskite photoactive layer and the second photoactive layer 7, which is an organic photoactive layer, are directly arranged to each other forming an integrated perovskite/organic solar cell stack architecture (IPOSC). There is no interconnecting unit 30 between photoactive layers 4,7.

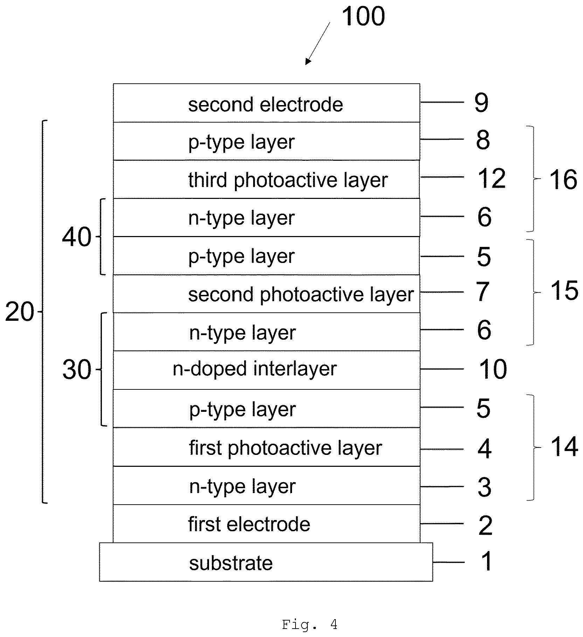

Fig. 4 shows a schematic illustration of an exemplary embodiment of an optoelectronic component 100 with a perovskite subcell 14 and two organic subcells 15,16 in cross-section. In this exemplary embodiment the optoelectronic component 100 is a photovoltaic element.

In a further embodiment of the invention the stack 20 comprises a third photoactive layer 12, wherein the third photoactive layer 12 comprises at least one perovskite absorber material or is an organic photoactive layer having a narrow band-gap comprising at least one donor and at least one acceptor as organic absorber materials forming a donor/acceptor heterojunction, preferably the third photoactive layer 12 is part of a third subcell 16. The third subcell 16 comprising an organic photoactive layer can be formed as BHJ, BHJ2, BHJ+, PHJ, or PHJ-cascade cell.

In this exemplary embodiment the stack 20 is substantially the same compared to Fig. 2, wherein between the second subcell 15 and the second electrode 9 there is additionally arranged a third subcell 16. The third subcell 16 comprises an n-type layer 6, a third photoactive layer 12 which is an organic photoactive layer, and a p-type layer 8. The second subcell and the third subcell are interconnected by an interconnecting unit 40 formed by the p-type layer 5 and the n-type layer 6.

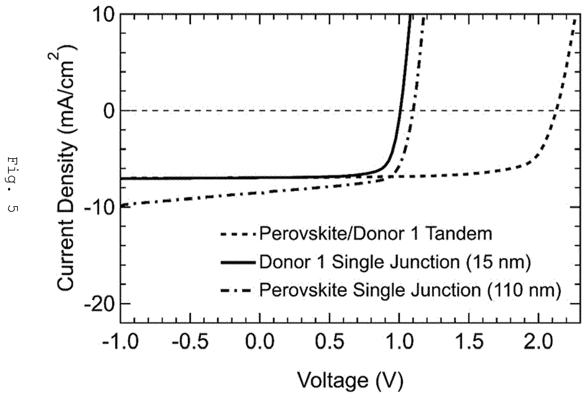

Fig. 5 shows in one embodiment the current-voltage curve of an optoelectronic component 100 formed as tandem cell comprising donor 1. In this embodiment the optoelectronic component 100 is a photovoltaic element.

The inventive photovoltaic element has the structure according to the first working example (table 1; Fig. 1) and was compared to the corresponding single junction cells. The stack architecture of the perovskite single junction cell corresponds to the tandem cell without an interconnecting unit 30 and without a second subcell 15. The stack architecture of the organic single junction cell corresponds to the tandem cell without an interconnecting unit 30 and without a first subcell 14.

The current-voltage curve was measured using a Keithley 2400 source measure unit under AM1.5 sun simulator (AM = air mass; AM=1.5, radiant power 1000 W/m²).

The current-voltage curve of the photovoltaic element is shown in Fig. 5. The parameters open-circuit voltage Voc, short-circuit current Jsc, fill factor FF, and the resulting cell performance (PCE) of the photovoltaic element are summarized in table 3.

**Table 3**

| Device | V_{oc} (V) | J_{sc} (mA/cm²) | FF (%) | PCE (%) |
|---|---|---|---|---|
| tandem cell: CsPbI₂Br (110 nm)/ donor 1 (15 nm) | 2.13 | 6.9 | 73 | 10.7 |
| single junction: CsPbI₂Br perovskite (110 nm) | 1.1 | 8.5 | 68 | 6.4 |
| single junction: donor 1 (15 nm) | 1.01 | 6.9 | 75 | 5.2 |

In the photovoltaic element comprising the tandem cell of the present invention the efficiency (PCE) was significantly improved to 10.7% compared to the perovskite single junction of 6.4% or the organic single junction of 5.2%.

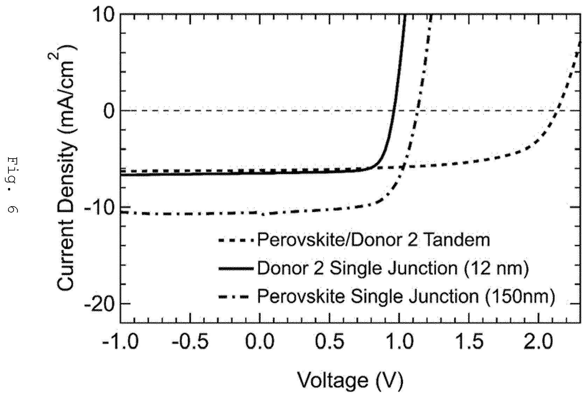

Fig. 6 shows in one embodiment the current-voltage curve of an optoelectronic component 100 formed as tandem cell comprising donor 2. In this embodiment the optoelectronic component 100 is a photovoltaic element.

The inventive photovoltaic element has the structure according to the second working example (table 2; Fig. 1) and was compared to the corresponding single junction cells, corresponding to Fig. 5.

The current-voltage curve of the photovoltaic element is shown in Fig. 6. The parameters open-circuit voltage Voc, short-circuit current Jsc, fill factor FF, and the resulting cell performance (PCE) of the photovoltaic element are summarized in table 4.

**Table 4**

| Devices | V_{oc} (V) | J_{sc} (mA/cm²) | FF (%) | PCE (%) |
|---|---|---|---|---|
| tandem cell: CsPbI₂Br (150 nm)/ donor 2 (12 nm) | 2.13 | 6.1 | 63 | 8.2 |
| single junction: CsPbI₂Br perovskite (150 nm) | 1.13 | 10.5 | 68 | 8.0 |
| single junction: donor 2 (12 nm) | 0.98 | 6.5 | 75 | 4.8 |

In the photovoltaic element comprising the tandem cell of the present invention the efficiency (PCE) was improved to 8.2% compared to the perovskite single junction of 8.0% or the organic single junction of 4.8%.

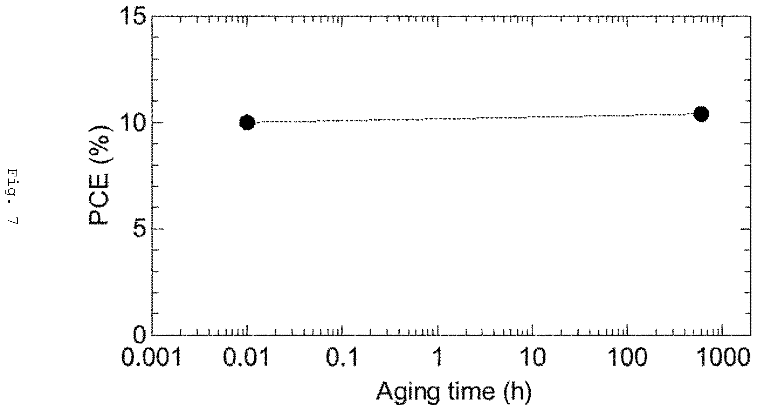

Fig. 7 shows in one embodiment shelf-life data of an optoelectronic component 100 with a perovskite photoactive layer 4, an organic photoactive layer 7 and an interconnecting unit 30 in between. In this embodiment the optoelectronic component 100 is a photovoltaic element.

The inventive photovoltaic element has the structure according to the first working example (table 1; Fig. 1), in particular comprising a first photoactive layer 4 of CsPbI₂Br and a second photoactive layer 7 of acceptor C60 and donor 1, wherein the layer thickness of the first photoactive layer 4, which is the perovskite photoactive layer, is 110 nm.

The following test was carried out to determine the shelf-life data, which indicate the aging of the photovoltaic element. The photovoltaic element was kept under dark in a nitrogen-filled glovebox atmosphere at 20°C for 600 h. The current-voltage curve was measured at different time intervals after the fabrication (Fig. 7). The shelf-life data after 600 h are summarized in table 5.

**Table 5**

| Aging time (h) | V_{oc} (V) | J_{sc} (mA/cm²) | FF (%) | PCE (%) |
|---|---|---|---|---|
| ~ 0 | 2.18 | 6.7 | 68.4 | 10.0 |
| 600 | 2.09 | 7.3 | 68.2 | 10.4 |

The data demonstrate that the efficiency (PCE) of the photovoltaic element with a perovskite/organic tandem cell of the present invention are very stable over an aging period of 600 h, which is in particular based on the constant fill factor (FF).

## Claims

1. Optoelectronic component (100), preferably photovoltaic element with at least one photovoltaic cell, comprising a first electrode (2), a second electrode (9), and a stack (20) arranged between the first electrode (2) and the second electrode (9), the stack (20) comprising at least a first photoactive layer (4) and a second photoactive layer (9), wherein the first photoactive layer (4) comprises at least one perovskite absorber material having a wide band-gap, and the second photoactive layer (7) is an organic photoactive layer having a narrow band-gap comprising at least one donor and at least one acceptor as organic absorber materials forming a donor/acceptor heterojunction, **characterized in that** the at least one donor of the second photoactive layer (7) is a A-D-A compound and/or a BODIPY compound.

2. Optoelectronic component (100) according to claim 1, wherein the at least one donor of the second photoactive layer (7) is a small molecule having a defined molecular structure and a molar mass of 100 g/mol to 1200 g/mol, preferably 100 g/mol to 1000 g/mol.

3. Optoelectronic component (100) according to claim 1 or 2, wherein the wide band-gap of the first photoactive layer (4) is more than 1.7 eV, preferably more than 1.8 eV, and/or the narrow band-gap of the second photoactive layer (7) is less than 1.6 eV, preferably less than 1.4 eV, and/or the wide band-gap of the first photoactive layer (4) is at least 0.2 eV, preferably at least 0.3 eV, larger compared to the narrow band-gap of the second photoactive layer (7).

4. Optoelectronic component (100) according to any of the preceding claims, wherein the first photoactive layer (4) absorbs in the blue-green-red spectral range, preferably in a range from 400 nm to 700 nm, more preferably in a range from 400 nm to 650 nm, and the second photoactive layer (7) absorbs in the red and near infrared spectral range, preferably in a range from 600 nm to 2500 nm, more preferably in a range from 600 nm to 1000 nm.

5. Optoelectronic component (100) according to any of the preceding claims, wherein the first photoactive layer (4) and the second photoactive layer (7) form an integrated perovskite/organic solar cell stack architecture (IPOSC), wherein the first photoactive layer (4) is directly arranged at the second photoactive layer (7).

6. Optoelectronic component (100) according to any of claims 1 to 4, wherein the first photoactive layer (4) is part of a first subcell (14) and the second photoactive layer (7) is part of a second subcell (15), wherein preferably the first subcell (14) and the second subcell (15) each are formed as a nip cell or a pin cell comprising an n-type layer (3,6), a photoactive layer (4,7), and a p-type layer (5,8), and/or preferably the second subcell (15) is formed as a BHJ, BHJ2, BHJ+, PHJ, or PHJ-cascade cell.

7. Optoelectronic component (100) according to claim 6, wherein the n-type layer (3,6) is formed by an intrinsic n-type sublayer and/or an n-doped n-type sublayer, and/or the p-type layer (5,8) is formed by an intrinsic p-type sublayer and/or a p-doped p-type sublayer, wherein preferably at least one intrinsic n-type sublayer and/or at least one intrinsic p-type sublayer is directly arranged at the first subcell (14) and/or the second subcell (15).

8. Optoelectronic component (100) according to any of the preceding claims, wherein the perovskite absorber material of the first photoactive layer (4) is an inorganic perovskite, preferably an all-inorganic perovskite, preferably the all-inorganic perovskite is selected from the group consisting of CsPbI₃, CsPbBrI₂, CsPbBr₂I, CsPbBr₃, CsPbCl₂I, CsPbClI₂, CsPbCl₃, CsPbBr₂Cl, CsPbBrCl₂, CsPbBrClI, and mixtures thereof.

9. Optoelectronic component according to any of the preceding claims, wherein the at least one acceptor of the second photoactive layer (7) is a fullerene or fullerene derivate, preferably fullerene C60.

10. Optoelectronic component (100) according to any of the preceding claims, wherein the first photoactive layer (4) is located at a side facing the light within the stack (20) of the optoelectronic component (100) as intended, preferably arranged at the first electrode (2), and the second photoactive layer (7) is located at a side facing away from the light within the stack (20) of the optoelectronic component (100) as intended, preferably arranged at the second electrode (9).

11. Optoelectronic component (100) according to any of claims 6 to 10, wherein the first subcell (14) and the second subcell (15) are interconnected by an interconnecting unit (30) forming a multijunction stack architecture.

12. Optoelectronic component (100) according to claim 11, wherein the interconnecting unit (30) comprises a p-type layer (5) and an n-type layer (6) arranged between the first photoactive layer (4) and the second photoactive layer (7), preferably the n-type layer (6) is formed by an intrinsic n-type sublayer and/or an n-doped n-type sublayer, and/or the p-type (5) layer is formed by an intrinsic p-type sublayer and/or a p-doped p-type sublayer, wherein preferably at least one intrinsic n-type sublayer and/or at least one intrinsic p-type sublayer is directly arranged at the first subcell (14) and/or the second subcell (15).

13. Optoelectronic component (100) according to claim 12, wherein within the stack (20) the p-type layer (5) of the interconnecting unit (30) is facing the first photoactive layer (4) and the n-type layer (6) of the interconnecting unit (30) is facing the second photoactive layer (7).

14. Optoelectronic component (100) according to claim 12 or 13, wherein the interconnecting unit (30) comprises an interlayer (10) arranged between the n-type layer (6) and the p-type layer (5), wherein the interlayer (10) is an n-doped interlayer, a p-doped interlayer, a metal layer, preferably from Au or an alloy thereof or Cu or an alloy thereof, a metal oxide layer, preferably from InOx, SnOx, or MoOx, or a transparent conductive oxide (TCO) layer, preferably from ITO or AZO, wherein preferably the interlayer (10) is an ultrathin layer having a layer thickness of 2 nm to 10 nm, preferably 2 nm to 5 nm.

15. Optoelectronic component (100) according to any of claims 11 to 13, wherein the interconnecting unit (30) comprises in sequence the following layers:
a) a doped or non-doped p-type layer (5) having a band-gap of more than 2.5 eV, wherein the p-type layer (5) has an ionization energy of at least 5.0 eV;
b) an n-doped interlayer (10) comprising a matrix material and at least one n-dopant, wherein the n-doped interlayer (10) has an electron affinity of more than 4.4 eV, preferably the n-dopant of the n-doped interlayer (10) has a HOMO more negative than -4.6 eV, and wherein the ratio of the at least one dopant is 1 to 30 vol.-%; and
c) a doped n-type layer (6) comprising an electron transport material (ETM) and at least one n-dopant, wherein the n-type layer (6) has an electron affinity of less than 4.4 eV.

16. Optoelectronic component (100) according to any of the preceding claims, wherein the stack (20) comprises a third photoactive layer (12), wherein the third photoactive layer (12) comprises at least one perovskite absorber material or is an organic photoactive layer having a narrow band-gap comprising at least one donor and at least one acceptor as organic absorber materials forming a donor/acceptor heterojunction, preferably the third photoactive layer (12) is part of a third subcell (16).

17. Optoelectronic component (100) according to any of the preceding claims, wherein the optoelectronic component (100) is a photovoltaic element or a photodetector, preferably the optoelectronic component is a flexible photovoltaic element.
